(19) Europäisches Patentamt / European Patent Office / Office européen des brevets

(11) **EP 4 181 222 A1**

(12) **EUROPEAN PATENT APPLICATION**
published in accordance with Art. 153(4) EPC

(43) Date of publication:
**17.05.2023 Bulletin 2023/20**

(21) Application number: **21836989.0**

(22) Date of filing: **08.06.2021**

(51) International Patent Classification (IPC):
*H01L 35/16* (2006.01)     *B22F 3/14* (2006.01)
*C22C 1/00* (2023.01)     *C22C 1/04* (2023.01)
*C22C 12/00* (2006.01)

(52) Cooperative Patent Classification (CPC):
**B22F 3/14; C22C 1/00; C22C 1/04; C22C 12/00; H10N 10/852**

(86) International application number:
**PCT/JP2021/021701**

(87) International publication number:
**WO 2022/009586 (13.01.2022 Gazette 2022/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.07.2020 JP 2020117153**

(71) Applicant: **Panasonic Intellectual Property Management Co., Ltd.**
**Osaka-shi, Osaka 540-6207 (JP)**

(72) Inventors:
• **YAMAMURA Ryosuke**
  **Osaka-shi, Osaka 540-6207 (JP)**
• **TAMAKI, Hiromasa**
  **Osaka-shi, Osaka 540-6207 (JP)**

(74) Representative: **Grünecker Patent- und Rechtsanwälte**
**PartG mbB**
**Leopoldstraße 4**
**80802 München (DE)**

(54) **THERMOELECTRIC CONVERSION MATERIAL, THERMOELECTRIC CONVERSION ELEMENT, THERMOELECTRIC CONVERSION MODULE, POWER GENERATION METHOD, AND HEAT TRANSFER METHOD**

(57) The present disclosure provides a novel thermoelectric conversion material. The thermoelectric conversion material of the present disclosure has a $La_2O_3$-type crystal structure and is of n-type. The thermoelectric conversion material has a composition represented by $Mg_{3+m-a-b}A_aB_bD_{2-e-f}E_eF_f$. D is at least one element selected from the group consisting of Sb and Bi. E is at least one element selected from the group consisting of P and As. m is a value of greater than or equal to -0.1 and less than or equal to 0.4. e is a value of greater than or equal to 0.001 and less than or equal to 0.25. A is at least one element selected from the group consisting of Y, Sc, La, and Ce. F is at least one element selected from the group consisting of Se and Te. a and f are values that satisfy a condition of $0.0001 \leq a + f \leq 0.06$. B is at least one element selected from the group consisting of Mn and Zn. b is a value of greater than or equal to 0 and less than or equal to 0.25.

FIG. 3

**Description**

Technical Field

The present disclosure relates to a thermoelectric conversion material, a thermoelectric conversion element, a thermoelectric conversion module, a method of power generation, and a method of heat transfer.

Background Art

A thermoelectric conversion material containing Mg is conventionally known. For example, PTL 1 discloses a thermoelectric conversion material represented by the chemical formula $Mg_{3+m}A_aB_bD_{2-e}E_e$ and a method of producing the thermoelectric conversion material. In the formula, A represents at least one selected from the group consisting of Ca, Sr, Ba and Yb. B represents at least one selected from the group consisting of Mn and Zn. D represents at least one selected from the group consisting of Sb and Bi. E represents at least one selected from the group consisting of Se and Te. The value of m is greater than or equal to -0.39 and less than or equal to 0.42, the value of a is greater than or equal to 0 and less than or equal to 0.12, the value of b is greater than or equal to 0 and less than or equal to 0.48, and the value of e is greater than or equal to 0.001 and less than or equal to 0.06.

PTL 2 discloses a thermoelectric conversion material represented by the chemical formula $Mg_{3+m-a}A_aB_{2-c-e}C_cE_e$ and a method of producing the thermoelectric conversion material. In the formula, the element A represents at least one selected from the group consisting of Ca, Sr, Ba, Nb, Zn, and Al. The element B represents at least one selected from the group consisting of Sb and Bi. The element C represents at least one selected from the group consisting of Mn, Si, and Cr. The element E represents at least one selected from the group consisting of Se and Te. The value of m is greater than or equal to -0.1 and less than or equal to 0.4, the value of a is greater than or equal to 0 and less than or equal to 0.1, the value of c is greater than or equal to 0 and less than or equal to 0.1, and the value of e is greater than or equal to 0.001 and less than or equal to 0.06.

NPL 1 discloses a polycrystalline thermoelectric conversion material represented by the chemical formula $Mg_{3+\delta}Sb_{1.5}Bi_{0.49}Te_{0.01}$ and a method of producing the polycrystalline thermoelectric conversion material. In this chemical formula, the value of $\delta$ is 0.1, 0.2, or 0.3.

NPL 2 discloses a monocrystalline thermoelectric conversion material represented by the chemical formula $Mg_3Sb_2$ and a method of producing the monocrystalline thermoelectric conversion material.

NPL 3 discloses a thermoelectric conversion material represented by the chemical formula $Mg_3Sb_{1.5-0.5x}Bi_{0.5-0.5x}Te_x$ and a method of producing the thermoelectric conversion material. In this chemical formula, the value of x is 0.04, 0.05, 0.08, or 0.20.

NPL 4 discloses a thermoelectric conversion material represented by the chemical formula $Mg_3Bi_{2-x}Pn_x$. In this chemical formula, Pn is P or Sb.

NPL 5 discloses a thermoelectric conversion material represented by the chemical formula $Mg_{3-x}Mn_xSb_2$ and a method of producing the thermoelectric conversion material. In this chemical formula, x satisfies the condition of $0 \leq x \leq 0.4$.

NPL 6 discloses a thermoelectric conversion material represented by the chemical formula $Mg_{3.05-x}Sc_xSbBi$ and a method of producing the thermoelectric conversion material. In this chemical formula, the value of x is 0.001, 0.0015, 0.003, 0.005, 0.009, 0.012, 0.015, 0.018, 0.020, 0.025, or 0.030.

NPL 7 discloses a thermoelectric conversion material represented by the chemical formula $Mg_{3.0}Y_xSb_{1.5}Bi_{0.5}$ and a method of producing the thermoelectric conversion material. In this chemical formula, the value of x is 0.03, 0.035, or 0.04.

NPL 8 discloses a thermoelectric conversion material represented by the chemical formula $Mg_{3.05-x}La_xSb_{1.5}Bi_{0.5}$ and a method of producing the thermoelectric conversion material. In this chemical formula, the value of x is 0.005, 0.01, or 0.03.

NPL 9 discloses a thermoelectric conversion material represented by the chemical formula $(Mg, Ce)_3Sb_2$.

NPL 10 discloses the value of the lattice thermal conductivity of the material represented by the chemical formula $Mg_{3.05}(Sb_{1-x}Bi_x)_{1.99}Te_{0.01}$.

Citation List

Patent Literature

PTL 1: Japanese Patent No. 6127281

**EP 4 181 222 A1**

PTL 2: Japanese Unexamined Patent Application Publication No. 2018-190953

Non Patent Literature

NPL 1: H. Tamaki et al., "Isotropic Conduction Network and Defect Chemistry in Mg3+6Sb2-Based Layered Zintl Compounds with High Thermoelectric Performance", Advanced Materials, (USA), 2016, Vol. 28, issue 46, p. 10182-10187
NPL 2: K. Imasato et al., "Metallic n-Type Mg3Sb2 Single Crystals Demonstrate the Absence of Ionized Impurity Scattering and Enhanced Thermoelectric Performance", Advanced Materials, (USA), 2020, Vol. 32, issue 16, p. 1908218
NPL 3: J. Zhangetal., "Discovery of high-performance low-cost n-type Mg3Sb2based thermoelectric materials with multi-valley conduction bands", Nature Communications, (UK), 2017, Vol. 8, Article number 13901
NPL 4: V. Ponnambalam et. al., "On the Thermoelectric Properties of Zintl Compounds Mg3Bi2-xPnx (Pn = P and Sb)", Journal of Electronic Materials, (USA), 2013, Vol. 42, No. 7, p. 1307-1312
NPL 5: S. Kim et. al, "Thermoelectric properties of Mn-doped Mg-Sb single crystals", Journal of Materials Chemistry A, (UK), 2014, Vol. 2, p. 12311-12316
NPL 6: X. Shi et. Al., "Efficient Sc-doped MgScSbBi thermoselectrics near room temperature", Chemistry of Materials, (USA), 2019, Vol. 31, No. 21, p. 8987-8994
NPL 7: S. W. Song et. Al., "Joint effect of magnesium and yttrium on enhancing thermoelectric properties of n-type Zintl Mg3+δY0.02Sb1.5Bi0.5", Materials Today Physics, (Netherlands), 2019, Vol. 8, p. 25-33
NPL 8: K. Imasato et al., "Improved stability and high thermoelectric performance through cation site doping in n-type La-doped Mg3Sb1.5Bi0.5", Journal of Materials Chemistry A, (UK), 2018, Vol. 6, p. 19941-19946
NPL 9: J. Li et al., "Defect Chemistry for N-Type Doping ofMg3Sb2-Based Thermoelectric Materials", Journal of Physical Chemistry C, (USA), 2019, Vol. 123, p. 20781-20788
NPL 10: K. Imasato et al., "Exceptional thermoelectric performance in Mg3Sb0.6Bi1.4for low-grade waste heat recovery", Energy & Environmental Science, (UK), 2019, Vol. 12, p. 965-971
NPL 11: C. G. Van de Walle et al., "First-principles calculations for defects and impurities: Applications to III-nitrides", Journal of Applied Physics, (USA), 2004, Vol. 95, p. 3581-3879

Summary of Invention

Technical Problem

The present disclosure provides a novel thermoelectric conversion material. Solution to Problem
A thermoelectric conversion material according to the present disclosure has a $La_2O_3$-type crystal structure and is of n-type, and

the thermoelectric conversion material has a composition represented by the following formula (1).

$$Mg_{3+m-a-b}A_aB_bD_{2-e-f}E_eF_f \qquad \text{formula (1)}$$

wherein

D is at least one element selected from the group consisting of Sb and Bi,
E is at least one element selected from the group consisting of P and As,
m is a value of greater than or equal to -0.1 and less than or equal to 0.4,
e is a value of greater than or equal to 0.001 and less than or equal to 0.25,
A is at least one element selected from the group consisting of Y, Sc, La, and Ce,
F is at least one element selected from the group consisting of Se and Te,
a and f are values that satisfy a condition of $0.0001 \leq a + f \leq 0.06$,
B is at least one element selected from the group consisting of Mn and Zn, and
b is a value of greater than or equal to 0 and less than or equal to 0.25. Advantageous Effects of Invention

According to the present disclosure, a novel thermoelectric conversion material can be provided.

Brief Description of Drawings

[Fig. 1] Fig. 1 is a schematic view of a $La_2O_3$-type crystal structure.
[Fig. 2] Fig. 2 is a graph indicating an example of simulation results for an X-ray diffraction pattern of a $La_2O_3$-type crystal structure.
[Fig. 3] Fig. 3 is a schematic view of a $La_2O_3$-type crystal structure of a thermoelectric conversion material according to the present disclosure.
[Fig. 4] Fig. 4 is a schematic view illustrating an example of a thermoelectric conversion module according to the present disclosure.

Description of Embodiments

Underlying Knowledge Forming Basis of the Present Disclosure

The performance of a thermoelectric conversion material is indicated by the thermoelectric figure of merit ZT. The thermoelectric figure of merit ZT is indicated as $ZT = S^2\sigma T/\kappa$ by using the Seebeck coefficient S, the electrical conductivity $\sigma$, the thermal conductivity $\kappa$, and the absolute temperature T. Here, the thermal conductivity $\kappa$ is indicted as $\kappa = \kappa_e + \kappa_{lat}$ by using the electron thermal conductivity $\kappa_e$ and the lattice thermal conductivity $\kappa_{lat}$.

PTL 1 discloses an n-type thermoelectric conversion material represented by the chemical formula $Mg_{3+m}A_aB_bD_{2-e}E_e$, which is based on $Mg_3(Sb,Bi)_2$. In PTL 1, E in this chemical formula is represented by at least one selected from the group consisting of Se and Te. In addition, the value of e is greater than or equal to 0.001 and less than or equal to 0.06. Under these conditions, the thermoelectric figure of merit ZT of the n-type thermoelectric conversion material represented by this chemical formula is 0.5 at 300 K and 1.5 at 700 K. These values of the thermoelectric figure of merit ZT are higher than the values of the thermoelectric figure of merit ZT of a thermoelectric conversion material that is represented by the chemical formula in which E is not contained, in other words, the chemical formula in which the value of e is 0.

The present inventors developed a new method that can more reliably predict the thermoelectric figure of merit ZT than a conventional method. More specifically, the present inventors combined calculation of the electronic state using the first principles calculation called density-functional theory (DFT) and a unique prediction model of the thermoelectric figure of merit ZT developed by the present inventors. In the present disclosure, comparisons between the empirical outcomes and the prediction outcomes of the thermoelectric figure of merit ZT were made for the thermoelectric conversion materials having the composition represented by $Mg_{3.05}Sb_xBi_{1.99-x}Te_{0.01}$ to confirm the validity of the prediction model of the thermoelectric figure of merit ZT developed by the present inventors. As a result, the prediction model of the thermoelectric figure of merit ZT developed by the present inventors accurately reproduced the physical property values such as the Seebeck coefficient S, the electrical conductivity $\sigma$, the thermal conductivity $\kappa$, and the thermoelectric figure of merit ZT of the n-type thermoelectric conversion material based on $Mg_3(Sb,Bi)_2$.

In view of the above, the present inventors calculated and predicted the thermoelectric figures of merit ZT of materials having unexamined compositions among crystalline materials based on $Mg_3(Sb,Bi)_2$ by using a combination of the calculation of the electronic state and the prediction model of the thermoelectric figure of merit ZT. The results showed that, when the thermoelectric conversion material is of n-type, the presence of at least one of P and As in the thermoelectric conversion material allows ZT to be higher than that of the $Mg_3(Sb,Bi)_2$ base itself. It is important to verify that a thermoelectric conversion material having a particular composition is actually synthesizable. Thus, the present inventors predicted, by using defect formation energy calculated with DFT, a range in which the composition of the thermoelectric conversion material having the calculated and predicted thermoelectric figure of merit ZT is stable. This resulted in new finding of a thermoelectric conversion material of the present disclosure that has an actually synthesizable composition.

Embodiments of Present Disclosure

Hereinafter, embodiments of the present disclosure will be described with reference to the drawings.

The thermoelectric conversion material of the present disclosure has a $La_2O_3$-type crystal structure and is of n-type. In addition, the thermoelectric conversion material of the present disclosure has a composition represented by the following formula (1). In the formula (1), D is at least one element selected from the group consisting of Sb and Bi. Furthermore, E is at least one element selected from the group consisting of P and As. The value of m is greater than or equal to -0.1 and less than or equal to 0.4. The value of e is greater than or equal to 0.001 and less than or equal to 0.25. A is at least one element selected from the group consisting of Y, Sc, La, and Ce. F is at least one element selected from the group consisting of Se and Te. The values of a and f satisfy the condition of $0.0001 \leq a + f \leq 0.06$. B is at least one element selected from the group consisting of Mn and Zn. The value of b is greater than or equal to 0 and less than or equal to 0.25.

$$Mg_{3+m-a-b}A_aB_bD_{2-e-f}E_eF_f \qquad \text{formula (1)}$$

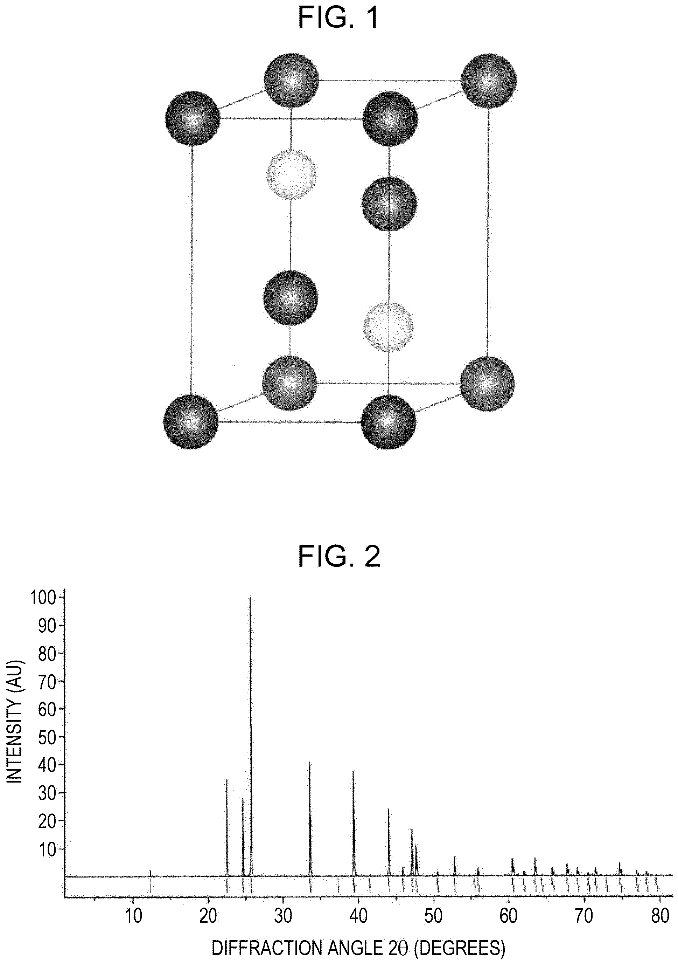

FIG. 1 schematically illustrates the $La_2O_3$-type crystal structure. For example, PTL 1 and PTL 2 state that a material based on $Mg_3(Sb,Bi)_2$ may have a $La_2O_3$-type crystal structure or a $CaAl_2Si_2$-type crystal structure, which belong to the space group P-3m1. (Sb,Bi) refers to at least one selected from the group consisting of Sb and Bi. FIG. 2 shows an example of simulation results for an X-ray diffraction pattern of $Mg_3(Sb,Bi)_2$ having a $La_2O_3$-type crystal structure. FIG. 2 shows simulation results for an X-ray diffraction pattern of a $La_2O_3$-type crystal structure or a $CaAl_2Si_2$-type crystal structure having a lattice constant in the a-axis direction of 0.457 nanometers, a lattice constant in the b-axis direction of 0.457 nanometers, and a lattice constant in the c-axis direction of 0.723 nanometers. The software VESTA available from https://jp-minerals.org/vesta/jp/download.html was used to provide the simulation results shown in FIG. 2. FIG. 2 has auxiliary lines, which indicate values of diffraction angles corresponding to the peaks of the X-ray diffraction pattern, between the X-ray diffraction pattern and the horizontal axis.

By checking the presence of diffraction peaks that characterize the $La_2O_3$-type crystal structure with an X-ray diffraction technique, it is possible to determine whether the thermoelectric conversion material has the $La_2O_3$-type crystal structure.

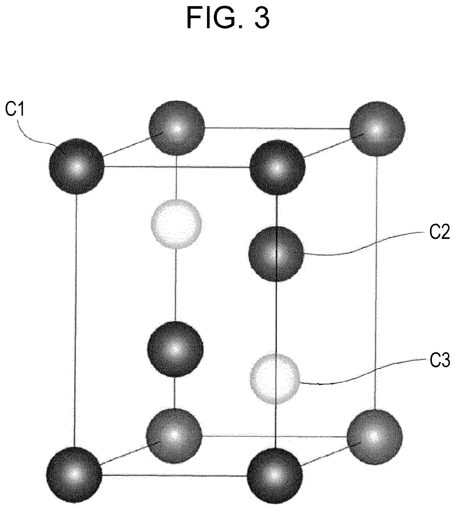

The thermoelectric conversion material of the present disclosure may be monocrystalline or polycrystalline. FIG. 3 schematically illustrates a $La_2O_3$-type crystal structure of the thermoelectric conversion material of the present disclosure. This crystal structure may have defects in which some of the Mg sites C1 are replaced by at least one element selected from the group consisting of Y, Sc, La, and Ce. Furthermore, this crystal structure may have defects in which some of the Mg sites C2 are replaced by at least one element selected from the group consisting of Mn and Zn. Furthermore, the crystal structure has defects in which some of the sites C3 composed of at least one element selected from the group consisting of Sb and Bi are replaced by at least one element selected from the group consisting of P and As. The crystal structure may have defects in which some other sites C3 are replaced by at least one element selected from the group consisting of Se and Te.

Such defects in the crystal structure of the thermoelectric conversion material may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material of the present disclosure relative to the intensity peaks of the X-ray diffraction pattern of $Mg_3(Sb,Bi)_2$ indicated in Fig. 2. The shift in the intensity peaks of the X-ray diffraction pattern results from the change in the lattice constant of the crystal structure. The intensity peaks of the X-ray diffraction pattern shift to the low-angle side as the lattice constant of the crystal structure increases, and the intensity peaks of the X-ray diffraction patterns shift to the high-angle side as the lattice constant decreases. For example, NPL 4 shows the X-ray diffraction pattern of the thermoelectric conversion material represented by the chemical formula $Mg_3Bi_{2-x}Pn_x$ and states that the peak positions shift depending on the compositions. In this chemical formula, Pn is P or Sb.

In the thermoelectric conversion material, E in the formula (1) may include P. In such a case, a thermoelectric conversion material having a thermoelectric figure of merit ZT higher than the thermoelectric figure of merit ZT of the material based on $Mg_3(Sb,Bi)_2$ and not containing P or As is readily produced.

In the thermoelectric conversion material, E in the formula (1) may include As. In such a case, a thermoelectric conversion material having a thermoelectric figure of merit ZT higher than the thermoelectric figure of merit ZT of the material based on $Mg_3(Sb,Bi)_2$ and not containing P or As is readily produced.

D in the formula (1) may include Sb and Bi, and the composition of the thermoelectric conversion material may be a composition represented by the following formula (2). The symbols representing the atoms and the symbols representing the number of atoms in the formula (2) have the same meanings as the symbols representing the atoms and the symbols representing the number of atoms in the formula (1). In the formula (2), the value of x is greater than or equal to 0.2 and less than or equal to 1.5. In this case, a thermoelectric conversion material having a thermoelectric figure of merit ZT higher than the thermoelectric figure of merit ZT of the material based on $Mg_3(Sb,Bi)_2$ and not containing P or As is readily produced.

$$Mg_{3+m-a-b}A_aB_bSb_xBi_{2-e-f-x}E_eF_f \qquad \text{formula (2)}$$

In the formula (1) representing the composition of the thermoelectric conversion material, the value of a may be 0. In such a case, a thermoelectric conversion material having a thermoelectric figure of merit ZT higher than the thermoelectric figure of merit ZT of the material based on $Mg_3(Sb,Bi)_2$ and not containing P or As is also readily produced. Furthermore, a thermoelectric conversion material can be produced without using a material containing Y, Sc, La, or Ce.

In the formula (1) representing the composition of the thermoelectric conversion material, the value of a may be greater than or equal to 0.0001 and less than or equal to 0.04, and the value of f may be 0. In such a case, a thermoelectric conversion material having a thermoelectric figure of merit ZT higher than the thermoelectric figure of merit ZT of the material based on $Mg_3(Sb,Bi)_2$ and not containing P or As is also readily produced. Furthermore, a thermoelectric conversion material can be produced without using a material containing Se or Te.

The thermoelectric conversion material having the composition represented by the formula (1) is stable and has a single crystalline phase in which multiple kinds of crystalline phases are not formed, or a single phase. The composition represented by the formula (1) corresponds to a stable composition range of $Mg_{3+m-a-b}A_aB_bD_{2-e-f}E_eF_f$. The stable composition range is a composition range which allows generation of only a crystalline material having the composition of $Mg_{3+m-a-b}A_aB_bD_{2-e-f}E_eF_f$, in other words, a composition range which allows $Mg_{3+m-a-b}A_aB_bD_{2-e-f}E_eF_f$ to stably form a solid solution. Outside the stable composition range, a crystalline phase of a composition other than the crystalline material having the composition of $Mg_{3+m-a-b}A_aB_bD_{2-e-f}E_eF_f$ may be precipitated, and it may be impossible to generate only a crystalline material having the composition of $Mg_{3+m-a-b}A_aB_bD_{2-e-f}E_eF_f$. In other words, this suggests that a solid solution is not stably formed outside the stable composition range.

The value of f, the value of b, the value of m, and the value of a in the formula (1) can be determined, for example, with reference to the above-listed PTLs and NPLs. It is understood from PTL 1 that, for the values of f and b, the ranges of $0.0 \leq b \leq 0.48$ and $0.0 \leq f \leq 0.06$ can fall in the stable composition range. It is understood from PTL 2 that, for the value of m, the range of $-0.1 \leq m \leq 0.4$ can fall in the stable composition range. It is understood from NPL 6 that, when A is Sc, for the value of a, the range of $0.0 \leq a \leq 0.03$ can fall in the stable composition range. It is understood from NPL 7 that, when A is Y, for the value of a, the range of $0.0 \leq a \leq 0.04$ can fall in the stable composition range. It is understood from NPL 8 that, when A is La, for the value of a, the range of $0.0 \leq a \leq 0.03$ can fall in the stable composition range. It is understood from NPL 9 that a thermoelectric conversion material can be more stably synthesized when A is Ce than when A is La.

It is understood from NPL 4 that, when E is P in the formula (1), for the value of e, the range of $0.0 \leq e \leq 0.5$ can fall in the stable composition range.

In addition, when E is As in the formula (1), the range of the value of e that corresponds to the stable composition range can be determined as follows. Specifically, the following calculation can be performed to determine the range of the value of e that allows the $La_2O_3$-type crystal structure to be stable in the crystalline material having the composition of $Mg_3Bi_{2-e}As_e$, which is based on $Mg_3(Sb,Bi)_2$. This calculation method is based on the defect formation theory of semiconductors described in NPL 11.

First, in $Mg_3Bi_2$, the defect formation energy $E_{form}$ in the case where Bi sites are replaced by As is estimated using the formula (3) below. In the formula (3), $E_{defect}$ is the total energy in the presence of defects, and $E_{pure}$ is the total energy of $Mg_3Bi_2$ in the absence of defects. In addition, m is an increase or decrease in the content of the i-th constituent element caused by defects, $\mu_i$ is the chemical potential of the i-th element, q is the charge amount of the defects, and $E_F$ is the Fermi energy of an electron. These energy values can be estimated by using a calculation technique based on DFT within the generalized gradient approximation.

[Math. 1]

$$E_{form}(\mu_i,q,E_F) = E_{defect} - E_{pure} - \sum n_i\mu_i + qE_F \qquad \text{formula (3)}$$

The volume density $N_D$ of the defects can be estimated based on the following formula (4) according to a Boltzmann distribution by using the defect formation energy $E_{form}$ obtained by the formula (3). In the formula (4), $N_{site}$ is the volume density of sites that possibly have a concerned defect, $K_B$ is the Boltzmann's constant, and T is the absolute temperature. The permissible range of a chemical potential $\mu_i$ of Bi atoms and As atoms was calculated by using the same method as the technique described in Journal of Materials Chemistry A, (UK), 2014, Vol. 2, p. 11235-11245. Furthermore, the defect density range in which Bi sites are replaced by As was estimated by using the relational expression (4).

[Math. 2]

$$N_D(\mu_i,q,E_F) = N_{site} \times \exp[-E_{form}(\mu_i,q,E_F)/k_BT] \qquad \text{formula (4)}$$

The results of the calculations indicate that, for the crystalline material having the composition of $Mg_3Bi_{2-e}As_e$, within the range of $0.0 \leq e \leq 0.70$, a single-phase $La_2O_3$-type crystal is obtained. When e is in the range of $0.0 \leq e \leq 0.70$, the $Mg_3Bi_{2-e}As_e$ crystalline material can stably form a solid solution.

The Bi atom radius of 0.150 nm is closer to the As atom radius of 0.120 nm than to the P atom radius of 0.109 nm. Thus, the range of the value of e that corresponds to the stable composition range in the case where E is As is theoretically broader than the range of the value of e that corresponds to the stable composition range in the case where E is P. Thus, the validity of the calculation is indicated by the result obtained through the above calculation in which the range of the value of e, $0.0 \leq e \leq 0.70$, which corresponds to the stable composition range in the case where E is As is broader than the range of the value of e, $0.0 \leq e \leq 0.5$, which corresponds to the stable composition range in the case where E is P referred to in NPL 4. The method for calculating the stable composition range of $Mg_{3+m-a-b}A_aB_bD_{2-e-f}E_eF_f$ is considered as reliable.

Furthermore, it was determined that, by the same method for calculating the stable composition range, the defect formation energy in the case where A is Sc and in the case where A is La is lower than the defect formation energy in the case where A is Y and a thermoelectric conversion material having a single phase is stably synthesizable. Based on the result and the descriptions of NPL 6 to NPL 9, the desirable value of a in the composition represented by the formula (1) can be determined with reference to a case in which A is Y. Thus, the formula (1) may satisfy the condition of $0.0 \leq a \leq 0.04$.

The thermoelectric performance of a material can be evaluated by the thermoelectric figure of merit ZT specific to the material. The thermoelectric figure of merit ZT is defined by the following formulas (5) and (6). In the formulas (5) and (6), S, $\sigma$, $\kappa_e$, and $\kappa_{lat}$ are the Seebeck coefficient, the electrical conductivity, the thermal conductivity of electrons, and the lattice thermal conductivity, respectively, of the overall material. T is the absolute temperature under the evaluation environment. The Vienna Ab initio Simulation Package (VASP) code, the parabolic band model, and the Kane band model were used in combination to predict S, $\sigma$, and $\kappa_e$. For the parabolic band model and the Kane band model, reference can be made to Chapters 3 and 4 of H. J. Goldsmid, "Introduction to Thermoelectricity", Springer, 2010.

$$ZT = S^2 \sigma T / \kappa \qquad \text{formula (5)}$$

$$\kappa = \kappa_e + \kappa_{lat} \qquad \text{formula (6)}$$

The formulas (7) to (11) are calculation formulas for calculating the characteristic values for the parabolic band model. The physical quantities in the formulas (7) to (11) are determined by providing an elementary quantity of the electric charge e, a band effective mass $m_I$, a degree of degeneracy at a band edge Nv, an average longitudinal elastic constant $C_1$, a deformation potential $\Xi$, a reduced Fermi energy $\eta$, and reduction energy at a band edge $\Delta E$. The reduced Fermi energy $\eta$ equals to $E_F/k_B T$, and the reduction energy at a band edge $\Delta E$ equals to $E/k_B T$. The signs in $S_p(\eta)$ and $F_i(\eta)$ include upper signs for the conduction band and lower signs for the valence band.

[Math. 3]

$$S_p = -k_B/e \times [F_2(\eta)/F_1(\eta) \mp \eta \pm \Delta E] \qquad \text{formula (7)}$$

$$\sigma_p = 2e^2 \hbar N_v C_1 / 3\pi m_I \Xi^2 \times F_1(\eta) \qquad \text{formula (8)}$$

$$\kappa_{e,p} = \sigma_p \times T \times (k_B/e)^2 \times [F_3(\eta)/F_1(\eta) - (F_2(\eta)/F_1(\eta))^2] \qquad \text{formula (9)}$$

$$F_i(\eta) = \int_{\Delta E}^{\pm\infty} dx \, (\pm x \mp \Delta E)^i \times (-\partial f_\pm(x,\eta)/\partial x) \qquad \text{formula (10)}$$

$$f_+(x,\eta) = 1/(1 + e^{x-\eta}), \ f_-(x,\eta) = 1 - f_+(x,\eta) \qquad \text{formula (11)}$$

The formulas (12) to (15) are calculation formulas for calculating the characteristic values for the Kane band model on the conduction band side.

[Math. 4]

$$S_k = -k_B/e \times [{}^1G^1_{-2}(\eta)/{}^0G^1_{-2}(\eta) - \eta + \Delta E] \qquad \text{formula (12)}$$

$$\sigma_k = 2e^2 \hbar N_v C_1 / 3\pi m_I \Xi^2 \times {}^0G^1_{-2}(\eta) \qquad \text{formula (13)}$$

$$\kappa_{e,k} = \sigma_k T (k_B/e)^2 [{}^2G^1_{-2}(\eta)/{}^0G^1_{-2}(\eta) - ({}^1G^1_{-2}(\eta)/{}^0G^1_{-2}(\eta))^2] \qquad \text{formula (14)}$$

$${}^iG^j_k(\eta) = 3 \int_{\Delta E}^{\infty} dx\, (x - \Delta E)^i \{x - \Delta E + \alpha(x - \Delta E)^2\}^j \times [\{1 + 2\alpha(x - \Delta E)\}^2 + 2]^{\frac{k}{2}} \times$$

$$(-\partial f_+(x,\eta)/\partial x) \qquad \text{formula (15)}$$

The above-described physical quantities are determined by providing a parameter $\alpha$, which indicates displacement from a parabolic structure, to the physical quantities for the parabolic band model. S, $\sigma$, and $\kappa_e$ of the overall material are determined by the following formulas (16), (17), and (18) using these physical quantities. In these formulas, i and j are indexes of the band obtained by the VASP code and include indexes of the parabolic band and the Kane band.
[Math. 5]

$$S = \Sigma_i S_i \sigma_i / \Sigma_i \sigma_i \quad \text{formula (16)}$$

$$\sigma = \Sigma_i \sigma_i \qquad \text{formula (17)}$$

$$\kappa_e = \Sigma_i \kappa_{e,i} + (T/2) \times \Sigma_{i,j} \sigma_i \sigma_j (S_i - S_j)^2 / \Sigma_i \sigma_i \qquad \text{formula (18)}$$

The reduced Fermi energy is calculated by using a defect concentration of A and F in the formula (1), which will be described later. The reduction energy at a band edge $\Delta E = E/k_B T$ and a band effective mass $m_l$ of the parabolic band are calculated by DFT using the VASP code. The average longitudinal elastic constant $C_l$ and the deformation potential function $\Xi$ are determined so as to reproduce the electrical conductivity of the $Mg_3(Sb,Bi)_2$ crystalline material, which is the base material.
The parameter $\alpha$ of the Kane band and the band effective mass $m_l$ can be calculated by fitting a band structure in three-directions ($k_l = k_x, k_y, k_z$) obtained by the VASP code according to the following formulas (19) and (20).
[Math. 6]

$$\hbar^2 k_l{}^2 / 2m_e = \frac{m_{k_l}}{m_e} E(k_l)(1 + \frac{k_B T}{\alpha} E(k_l)) \qquad \text{formula (19)}$$

$$1/m1 = (1/m_{k_x} + 1/m_{k_y} + 1/m_{k_z})/3 \qquad \text{formula (20)}$$

The lattice thermal conductivity can be calculated by fitting according to the following formula (21). In the formula (21), x is a proportion of Bi that occupies the site C3 in FIG. 3. The values of A and B can be determined to reproduce the calculated lattice thermal conductivity of $Mg_{3.05}(Sb_{1-x}Bi_x)_{1.99}Te_{0.01}$ disclosed in NPL 10.
[Math. 7]

$$1/\kappa_{lat} = A + B \times x(1-x) \qquad \text{formula (21)}$$

The reduced Fermi energy and the concentration of defects can be linked to each other by the following formulas (22) and (23).
[Math. 8]

$$n(\eta) = C_K \times N_K \qquad \text{formula (22)}$$

$$n(\eta) = n_{CB}(\eta) + n_{kane}(\eta) - n_{VB}(\eta) \quad \text{formula (23)}$$

In the formulas (22) and (23), n ($\eta$) is a carrier concentration of electrons, $C_K$ is a carrier activation rate of the atom K contained in A or F in the formula (1) as dopant, and $N_K$ is a concentration of the atom K. In the formulas (22) and (23), $n_{CB}$ ($\eta$) is a carrier concentration of electrons derived from the parabolic band in the conduction band, $n_{kane}$ ($\eta$) is a carrier concentration of electrons derived from the Kane band in the conduction band, and $n_{VB}$ ($\eta$) is a whole carrier concentration in the valance band. These are calculated by using the following formulas (24), (25), and (26).

[Math. 9]

$$n_{CB}(\eta) = \sum N_v (2m_d k_B T)^{3/2}/2\pi^2\hbar^3 \times \int_{\Delta E}^{\infty} dx\, (x - \Delta E)^{1/2} \times f_+(x,\eta) \qquad \text{formula (24)}$$

$$n_{kane}(\eta) = \sum N_v (2m_d k_B T)^{3/2}/2\pi^2\hbar^3 \times \int_{\Delta E}^{\infty} dx\, \{x - \Delta E + \alpha(x - \Delta E)^2\}^{1/2} \times \{1 + 2\alpha(x - \Delta E)\} \times f_+(x,\eta) \qquad \text{formula (25)}$$

$$n_{VB}(\eta) = \sum N_v (2m_d k_B T)^{3/2}/2\pi^2\hbar^3 \times \int_{-\infty}^{\Delta E} dx\, (-x + \Delta E)^{1/2} \times f_-(x,\eta) \qquad \text{formula (26)}$$

The carrier activation rate can be estimated from relation between the starting concentration of the dopant and the measured value of the carrier concentration for each crystalline material. The combination of the formulas (12), (22), and (23) can be compared with the value of the Seebeck coefficient of the base material $Mg_3(Sb,Bi)_2$ to calculate the reduced Fermi energy, which is the parameter to predict the thermoelectric properties of a target material.

The calculation in accordance with the above-described calculation procedure can determine the thermoelectric figure of merit ZT for the compositions of the $Mg_{3+m-a-b}A_aB_bD_{2-e-f}E_eF_f$ crystalline material. Here, the value of m in the formula (1) seems to have little influence on the calculation results of the physical property values and the thermoelectric figure of merit ZT when being in the range disclosed in NPL 1. It is understood that, when the value of m is within the range disclosed in NPL 1, in the actual synthesis evaluation, the Seebeck coefficient of the material is negative, in other words, n-type thermoelectric conversion properties are exhibited, and the absolute value of the Seebeck coefficient is not changed. As described above, when n-type thermoelectric properties are exhibited, the value of m seems to have little influence on ZT. Thus, when a value in the stable composition range used in the synthesis in PTL 2 is employed as the value of m, changes in the physical property values caused by the value of m are negligible in the calculation.

The method of producing a thermoelectric conversion material is not limited to a specific method. The thermoelectric conversion material may be produced as follows, for example. Mg, at least one of Sb and Bi, at least one of P and As, and an element that can be contained as A or F as needed in the formula (1) in elemental form are weighed to be in a desired stoichiometric proportion. The weighed materials in elemental form are sealed in a stainless-steel container together with stainless-steel balls under an argon atmosphere. Then, the materials are pulverized and mixed by a planetary ball milling technique. In this process, stearic acid may be added to prevent alloy powder derived from the materials from attaching to the stainless-steel container. The alloy powder generated in this way is put into a graphite mold and is subjected to, while being pressurized, spark plasma sintering including heating using a pulsed current, to provide a bulk polycrystalline sintered object. In this way, a thermoelectric conversion material is produced. Instead of the spark plasma sintering, a known sintering technique such as hot pressing may be used. Alternatively, after the pulverization and mixing of the materials, a heating process may be performed to prepare alloy powder as a precursor, and the alloy powder may be sintered to produce a thermoelectric conversion material. Further alternatively, a metal flux method may be employed to produce a monocrystalline material to obtain a thermoelectric conversion material.

The thermoelectric conversion material according to the present disclosure may contain multiple elements as indicated by the formula (1). According to PTL 2, when the material contains elements, such as Ca, Sr, Ba, Nb, Zn, Al, Mn, Si, Cr, and Se, a thermoelectric conversion material based on $Mg_3(Sb,Bi)_2$ can be synthesized and produced by the same method as the above-described production method. As described above, the composition represented by the formula (1) is determined based on the stable composition range. Thus, a thermoelectric conversion material having the composition represented by the formula (1) can be stably synthesized and produced by the above-described production method.

NPL 4 indicates that p-type $Mg_3Bi_{1.5}P_{0.5}$ can be stably synthesized. The Bi atom radius of 0.150 nm is closer to the As atom radius of 0.120 nm than to the P atom radius of 0.109 nm. It is understood from this that Bi of $Mg_3Bi_2$ is more likely to be replaced by As than by P. The above suggests that the thermoelectric conversion material having the composition represented by the formula (1) can be produced with reference to the production methods described in NPLs 1 and 2 and PTLs 1 and 2.

A thermoelectric conversion element including the thermoelectric conversion material according to the present disclosure can be provided. The thermoelectric conversion element can function as an n-type thermoelectric conversion element.

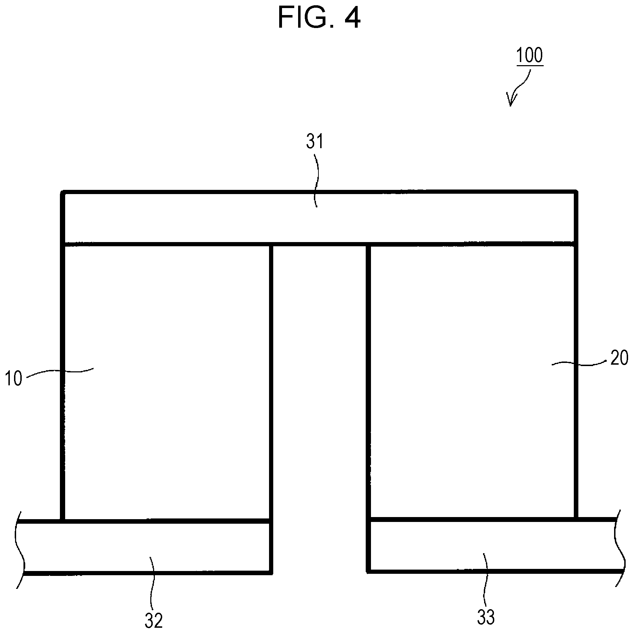

FIG. 4 illustrates an example of a thermoelectric conversion module according to the present embodiment. A thermoelectric conversion module 100 includes an n-type thermoelectric conversion element 10, a p-type thermoelectric conversion element 20, a first electrode 31, a second electrode 32, and a third electrode 33. The n-type thermoelectric conversion element 10 contains the thermoelectric conversion material according to the present disclosure. The p-type thermoelectric conversion element 20 may be a known p-type thermoelectric conversion element. The first electrode 31 electrically connects one end of the n-type thermoelectric conversion element 10 and one end of the p-type thermoelectric conversion element 20 to each other. The second electrode 32 is electrically connected to another end of the n-type thermoelectric conversion element 10. The third electrode 33 is electrically connected to another end of the p-type thermoelectric conversion element.

The thermoelectric conversion material according to the present disclosure can be employed to provide, for example, a method of power generation including the following items (Ia) and (IIa):

(Ia) providing the thermoelectric conversion material with a temperature difference; and
(IIa) deriving electric power from thermoelectromotive force generated in the thermoelectric conversion material due to the temperature difference provided in (Ia).

For example, an electrode is disposed on each of one end and another end of the thermoelectric conversion material according to the present disclosure. A temperature difference is provided such that the temperature of the one end becomes high and the temperature of the other end becomes low. This moves n-type carriers from the one end of the thermoelectric conversion material to the other end of the thermoelectric conversion material, resulting in generation of electric power.

The thermoelectric conversion material according to the present disclosure can provide, for example, a method of heat transfer including the following items (Ib) and (IIb):

(Ib) allowing a current to flow through the thermoelectric conversion material; and
(IIa) transferring heat by the current flowing in (Ib).

For example, heat is transferred from one end to another end of the thermoelectric conversion material. In this case, when the direction of the current is reversed, the direction in which heat is transferred in the thermoelectric conversion material is reversed. Thus, heat can also be transferred from the other end to the one end of the thermoelectric conversion material.

EXAMPLES

Hereinafter, the present disclosure will be described in detail with reference to the examples. However, the thermoelectric conversion material according to the present disclosure is not limited to the specific aspects described below.

To verify the validity of the prediction model based on the calculation for the material having the composition represented by the formula (1), synthesis of the $Mg_{3.05}Sb_xBi_{1.99-x}Te_{0.01}$ crystalline material based on $Mg_3(Sb,Bi)_2$ and evaluation of the thermoelectric properties were performed by the following methods.

Elemental Mg, Sb, Bi, and Te as materials were weighed to be in a desired composition ratio, and the materials were sealed in a stainless-steel container together with stainless-steel balls under an argon atmosphere having a diameter of 10 mm. Then, the materials were pulverized and mixed for two hours by the 8000D mixer/mill available from SPEX to provide a powder mixture. The generated powder mixture was put into a graphite mold and sintered under an argon atmosphere using a spark plasma sintering technique to provide a cylindrical compact. In this way, the crystalline material having the composition of $Mg_{3.05}Sb_xBi_{1.99-x}Te_{0.01}$ based on $Mg_3(Sb,Bi)_2$ was produced.

The produced compact was cut into strips and pellets. The samples cut into strips were subjected to measurements of the Seebeck coefficient S and the electrical conductivity σ using ZEM-3 available from ADVANCE RIKO, Inc. The samples cut into pellets were subjected to evaluation of the thermal conductivity κ using LFA-447 available from NETZSCH. In this way, the performance of the produced crystalline material as the thermoelectric conversion material was examined.

Table 1 indicates the empirical values obtained by using the samples actually synthesized for the physical property values and the thermoelectric figure of merit ZT of the materials each having the composition of $Mg_{3.05}Sb_xBi_{1.99-x}Te_{0.01}$ as comparative examples 1, 3, 5, 7, 9, and 11. In addition, Table 1 indicates the calculated values obtained by using the above-described prediction model, which is a combination of the VASP code, the parabolic band model, and the Kane band model, as comparative examples 2, 4, 6, 8, 10, and 12. The empirical values and the calculated values are both values at 330 K.

[Table 1]

| | | x | Seebeck coefficient S (μV/K) | Electrical conductivity σ (S/cm) | Thermal conductivity κ (W/mK) | Dimensionless figure of merit ZT |
|---|---|---|---|---|---|---|
| $Mg_{3.05}Sb_xBi_{1.99-x}Te_{0.01}$ | | | | | | |
| Com. Ex. 1 (experiment) | | 0.0 | -136 | 2174 | 2.80 | 0.47 |
| Com. Ex. 2 (calculation) | | 0.0 | -127 | 2188 | 2.06 | 0.56 |
| Com. Ex. 3 (experiment) | | 0.2 | -132 | 2051 | 2.29 | 0.51 |
| Com. Ex. 4 (calculation) | | 0.2 | -121 | 2045 | 1.94 | 0.51 |
| Com. Ex. 5 (experiment) | | 0.3 | -135 | 1865 | 2.05 | 0.55 |
| Com. Ex. 6 (calculation) | | 0.3 | -128 | 1719 | 1.71 | 0.55 |
| Com. Ex. 7 (experiment) | | 0.4 | -142 | 1649 | 1.83 | 0.60 |
| Com. Ex. 8 (calculation) | | 0.4 | -137 | 1396 | 1.44 | 0.60 |
| Com. Ex. 9 (experiment) | | 0.6 | -159 | 1066 | 1.37 | 0.65 |
| Com. Ex. 10 (calculation) | | 0.6 | -159 | 1004 | 1.13 | 0.74 |
| Com. Ex. 11 (experiment) | | 1.5 | -192 | 605 | 1.01 | 0.73 |
| Com. Ex. 12 (calculation) | | 1.5 | -187 | 602 | 0.84 | 0.83 |

The results of the comparative examples 2, 4, 6, 8, 10, and 12, which are based on the calculation, and the results of the comparative examples 1, 3, 5, 7, 9, and 11, which are actually synthesized and empirically estimated, are substantially the same as each other. The validity of the prediction model based on the calculation is confirmed over a broad stable composition range of Sb and Bi represented by the value of x. This indicates that the above-described prediction model can be used to explain the crystalline material based on $Mg_3(Sb,Bi)_2$, which will be described below.

A study was further conducted on materials to which P or As was added by using the above-described prediction model having the valid calculated values over a broad stable composition range of Sb and Bi.

(EXAMPLES 1 to 22)

A crystalline material having a composition of $Mg_{3+m}Sb_xBi_{1.99-x-e}P_eTe_{0.01}$ can be produced as follows, for example. First, elemental Mg, Sb, Bi, Te, and P (red phosphorus) as materials were weighed to be in a desired composition ratio and sealed in a stainless-steel container together with stainless-steel balls under an argon atmosphere. Then, the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of $Mg_{3+m}Sb_xBi_{1.99-x-e}P_eTe_{0.01}$ based on $Mg_3(Sb,Bi)_2$ can be produced.

Referring to FIG. 3, the crystalline material having the composition represented by $Mg_{3+m}Sb_xBi_{1.99-x-e}P_eTe_{0.01}$ has defects in which some of the sites C3 composed of at least one selected from the group consisting of Sb and Bi are replaced by P and Te. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the peaks of the X-ray diffraction patterns shift to the high-angle side as the lattice constant decreases.

The crystalline material having the composition of $Mg_{3+m}Sb_xBi_{1.99-x-e}P_eTe_{0.01}$ is represented by the formula (1) in which the value of each of a and b is 0, D is at least one of Sb and Bi, the value of x is $0.0 \leq x \leq 1.99-e$, E is P, F is Te, and the value of f is 0.01. In this crystalline material, the value of a is within the stable composition range of $0.0 \leq a \leq 0.04$. In this crystalline material, the values of b and f are within the stable composition ranges derived with reference to PTL 1. The value of m satisfies the condition of $-0.1 \leq m \leq 0.4$ with reference to PTL 2. Furthermore, the value of e satisfies the condition of $0.0 \leq e \leq 0.5$ with reference to NPL 4.

The thermoelectric figure of merit ZT of the crystalline material having the composition of $Mg_{3+m}Sb_xBi_{1.99-x-e}P_eTe_{0.01}$ was calculated by using the same method as the method of calculating the thermoelectric figure of merit ZT of the above-described crystalline material of $Mg_{3+m-a-b}A_aB_bD_{2-e-f}E_eF_f$. The Seebeck coefficient S and the thermoelectric figure of merit ZT of the crystalline materials having the composition of $Mg_{3+m}Sb_xBi_{1.99-x-e}P_eTe_{0.01}$ were calculated in accordance with the above-described calculation procedure using the formulas (5) to (26), for example. Here, the value of m in $Mg_{3+m}Sb_xBi_{1.99-x-e}P_eTe_{0.01}$ has little influence on the physical property values and the thermoelectric figure of merit ZT when being in the range disclosed in NPL 1. It is understood that, when the value of m is in the range disclosed in NPL 1, the Seebeck coefficient of the material is negative, in other words, n-type thermoelectric properties are exhibited, and the absolute value of the Seebeck coefficient does not change in the practical synthesis evaluation. As described above, it is understood that, when a material exhibits n-type thermoelectric properties, the value of m has little influence on ZT. In the evaluation of $Mg_{3+m}Sb_xBi_{1.99-x-e}P_eTe_{0.01}$, the stable composition range in the synthesis in PTL 2 was employed as m, and the changes of the physical property values due to the value of m was ignored in the following calculations. Table 2 shows the calculated values of the thermoelectric conversion properties of $Mg_{3+m}Sb_xBi_{1.99-x-e}P_eTe_{0.01}$ at 330 K.

[Table 2]

| | x | e | Seebeck coefficient S ($\mu$V/K) | Electrical conductivity $\sigma$ (S/cm) | Thermal conductivity $\kappa$ (W/mK) | Dimensionless figure of merit ZT |
|---|---|---|---|---|---|---|
| | | | | $Mg_{3+m}Sb_xBi_{1.99-X-e}PeTe_{0.01}$ | | |
| Com. Ex. 2 | 0.0 | 0.0 | -127 | 2188 | 2.06 | 0.56 |
| Ex. 1 | 0.0 | 0.001 | -127 | 2202 | 2.06 | 0.57 |
| Ex. 2 | 0.0 | 0.05 | -131 | 2161 | 1.94 | 0.63 |
| Ex. 3 | 0.0 | 0.125 | -127 | 2246 | 1.93 | 0.62 |
| Ex. 4 | 0.0 | 0.25 | -118 | 2545 | 2.09 | 0.56 |
| Com. Ex. 13 | 0.0 | 0.5 | -75 | 3909 | 3.39 | 0.22 |
| Ex. 5 | 0.2 | 0.001 | -122 | 2034 | 1.94 | 0.51 |
| Ex. 6 | 0.2 | 0.05 | -141 | 1566 | 1.60 | 0.64 |
| Ex. 7 | 0.2 | 0.125 | -166 | 1195 | 1.31 | 0.83 |
| Ex. 8 | 0.2 | 0.25 | -182 | 1231 | 1.23 | 1.09 |
| Ex. 9 | 0.3 | 0.001 | -129 | 1708 | 1.70 | 0.55 |
| Ex. 10 | 0.3 | 0.05 | -152 | 1280 | 1.38 | 0.71 |
| Ex. 11 | 0.3 | 0.125 | -173 | 1032 | 1.17 | 0.87 |
| Ex. 12 | 0.3 | 0.25 | -184 | 1032 | 1.14 | 1.02 |
| Ex. 13 | 0.4 | 0.001 | -138 | 1387 | 1.44 | 0.61 |
| Ex. 14 | 0.4 | 0.05 | -161 | 1067 | 1.19 | 0.77 |
| Ex. 15 | 0.4 | 0.125 | -176 | 938 | 1.07 | 0.90 |

(continued)

| Mg$_{3+m}$Sb$_x$Bi$_{1.99-X-e}$PeTe$_{0.01}$ | | | | | | |
|---|---|---|---|---|---|---|
| | x | e | Seebeck coefficient S (μV/K) | Electrical conductivity σ (S/cm) | Thermal conductivity κ (W/mK) | Dimensionless figure of merit ZT |
| Ex. 16 | 0.4 | 0.25 | -181 | 937 | 1.06 | 0.96 |
| Ex. 17 | 0.6 | 0.001 | -160 | 999 | 1.12 | 0.75 |
| Ex. 18 | 0.6 | 0.05 | -173 | 876 | 1.00 | 0.87 |
| Ex. 19 | 0.6 | 0.125 | -178 | 846 | 0.97 | 0.91 |
| Ex. 20 | 0.6 | 0.25 | -180 | 848 | 0.96 | 0.94 |
| Ex. 21 | 1.0 | 0.001 | -182 | 725 | 0.87 | 0.91 |
| Ex. 22 | 1.0 | 0.05 | -182 | 726 | 0.87 | 0.91 |
| Ex. 23 | 1.0 | 0.125 | -182 | 728 | 0.87 | 0.91 |
| Ex. 24 | 1.0 | 0.25 | -182 | 730 | 0.88 | 0.91 |
| Ex. 25 | 1.5 | 0.001 | -187 | 602 | 0.84 | 0.83 |
| Ex. 26 | 1.5 | 0.05 | -187 | 603 | 0.85 | 0.82 |
| Ex. 27 | 1.5 | 0.25 | -187 | 605 | 0.90 | 0.77 |
| Ex. 28 | 1.74 | 0.001 | -189 | 550 | 0.87 | 0.74 |
| Ex. 29 | 1.74 | 0.05 | -189 | 551 | 0.89 | 0.73 |
| Ex. 30 | 1.74 | 0.25 | -189 | 552 | 0.99 | 0.66 |

As indicated in Table 2, the crystalline materials having the composition of Mg$_{3+m}$Sb$_x$Bi$_{1.99-x-e}$P$_e$Te$_{0.01}$ exhibited n-type thermoelectric conversion properties in which the value of the Seebeck coefficient S is negative when the condition of $0.001 \leq e \leq 0.25$ is satisfied with x being in the range of $0.0 \leq x \leq 1.74$. In addition, the thermoelectric figures of merit ZT in this case were high enough to exceed the thermoelectric figure of merit ZT of the comparative examples 2 and 13. The crystalline materials not containing one of Sb and Bi showed the high thermoelectric figure of merit ZT substantially equal to or higher than the thermoelectric figure of merit ZT of the comparative example 2 satisfying e = 0 and not containing P. For example, in Table 2, the examples 1 to 4 in which x = 0.0 and the example 30 in which x = 1.74 showed the thermoelectric figure of merit ZT substantially equal to or higher than that of the comparative example 2. The examples 5 to 29 in which the value of x is within the range of $0.2 \leq x \leq 1.74$, in other words, in which both Sb and Bi are contained, showed the thermoelectric figure of merit ZT that exceeds the thermoelectric figure of merit ZT of the examples 1 to 4 and the example 30. In the examples 1 to 4, x = 0.0. In the example 30, x = 1.74 and e = 0.25. Furthermore, in the examples 5 to 20 in which the value of x satisfies the condition of $0.2 \leq x \leq 0.6$, it was confirmed that the thermoelectric figure of merit ZT increases as the value of e increases within the range of $0.001 \leq e \leq 0.25$.

(EXAMPLES 31 to 60)

A crystalline material having a composition of Mg$_{3+m}$Sb$_x$Bi$_{1.99-x-e}$As$_e$Te$_{0.01}$ can be produced, for example, as follows. First, elemental Mg, Sb, Bi, Te, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of Mg$_{3+m}$Sb$_x$Bi$_{1.99-x-e}$As$_e$Te$_{0.01}$ based on Mg$_3$(Sb,Bi)$_2$ can be produced.

Referring to FIG. 3, the crystalline material having the composition represented by Mg$_{3+m}$Sb$_x$Bi$_{1.99-x-e}$As$_e$Te$_{0.01}$ has defects in which some of the sites C3 composed of at least one selected from the group consisting of Sb and Bi are replaced by As and Te. These defects are similar in pattern to the defects of the above-described Mg$_{3+m}$Sb$_x$Bi$_{1.99-x-e}$P$_e$Te$_{0.01}$ crystalline material. When some of the sites C3 are replaced, the sites C3 are more likely to be replaced by an element having an atom radius closer to the atom radius of Bi. The atom radius of Bi is 0.150 nm. In contrast, the atom radius of the element As is 0.120 nm, and the atom radius of the element P is 0.109 nm. Thus, it is understood that the sites C3 are more likely to be replaced by the element As than by the element P. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the intensity peaks of the X-ray diffraction patterns shift to the high-angle side as the lattice constant decreases.

The stable composition range of the crystalline material having the composition of $Mg_{3+m}Sb_xBi_{1.99-x-e}As_eTe_{0.01}$ is determined by using the same method as the method of determining the stable composition range of the above-described $Mg_{3+m-a-b}A_aB_bD_{2-e-f}E_eF_f$ crystalline material. The crystalline material is represented by the formula (1) in which the value of each of a and b is 0, D is at least one of Sb and Bi, and the value of x satisfies $0.0 \leq x \leq 1.99-e$, E is As, F is Te, and the value of f is 0.01. In this crystalline material, the value of a is within the stable composition range of $0.0 \leq a \leq 0.04$. The values of b and f of the crystalline material are within the stable composition range derived with reference to PTL 1. The value of m of the crystalline material is $-0.1 \leq m \leq 0.4$ with reference to PTL 2.

Referring to NPL 4, when E is P, the value of e is $0.0 \leq e \leq 0.5$. In contrast, when E is As, the range of e that allows stable synthesis of the crystalline material was calculated by using the above formulas (3) and (4). As a result, it was found that, within the range of $0.0 \leq e \leq 0.70$, the crystalline material having the composition of $Mg_3Bi_{2-e}As_e$ has a single-phase $La_2O_3$-type crystal. In other words, this suggests that, within the range of $0.0 \leq e \leq 0.70$, the $Mg_3Bi_{2-e}As_e$ crystalline material stably form a solid solution and thus the above-described production method can synthesize and produce the crystalline material. Thus, the stable composition range of the value of e, $0.0 \leq e \leq 0.70$, in the case where E is As is broader than the stable composition range of $0.0 \leq e \leq 0.5$ in the case where E is P.

As described above, the Bi atom radius of 0.150 nm is closer to the As atom radius of 0.120 nm than to the P atom radius of 0.109 nm, and thus Bi is more likely to be replaced by As than by P. In other words, this suggests that the stable composition range relating to the value of e in the case where E is As is broader than the stable composition range relating to the value of e in the case where E is P. Thus, the evaluation results in which the stable composition range of the value of e, $0.0 \leq e \leq 0.70$, in the case where E is As is broader than the stable composition range of the value of e, $0.0 \leq e \leq 0.5$, in the case where E is P described in NPL 4 is consistent with theory. This indicates that the method of determining the stable composition range disclosed herein is reliable. Here, the thermoelectric conversion properties were predicted with the value of e for E within the range of $0.0 \leq e \leq 0.5$, which corresponds to the narrower stable composition range in the case where E is P. The thermoelectric conversion properties of $Mg_{3+m}Sb_xBi_{1.99-x-e}As_eTe_{0.01}$ at 330 K was predicted as those of $Mg_{3+m}Sb_xBi_{1.99-x-e}P_eTe_{0.01}$. The table 3 shows the calculated values.

[Table 3]

| $Mg_{3+m}Sb_xBi_{1.99-x-e}As_eTe_{0.01}$ | | | | | | |
|---|---|---|---|---|---|---|
| | x | e | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 2 | 0.0 | 0.0 | -127 | 2188 | 2.06 | 0.56 |
| Ex. 31 | 0.0 | 0.001 | -127 | 2202 | 2.06 | 0.56 |
| Ex. 32 | 0.0 | 0.05 | -131 | 2108 | 1.97 | 0.60 |
| Ex. 33 | 0.0 | 0.125 | -136 | 2056 | 1.84 | 0.68 |
| Ex. 34 | 0.0 | 0.25 | -112 | 2506 | 2.15 | 0.48 |
| Com. Ex. 14 | 0.0 | 0.5 | -63 | 3170 | 3.33 | 0.12 |
| Ex. 35 | 0.2 | 0.001 | -121 | 2041 | 1.94 | 0.51 |
| Ex. 36 | 0.2 | 0.05 | -133 | 1822 | 1.75 | 0.60 |
| Ex. 37 | 0.2 | 0.125 | -154 | 1483 | 1.48 | 0.78 |
| Ex. 38 | 0.2 | 0.25 | -178 | 1230 | 1.23 | 1.05 |
| Ex. 39 | 0.3 | 0.001 | -129 | 1711 | 1.70 | 0.55 |

(continued)

| Mg$_{3+m}$Sb$_x$Bi$_{1.99-x-e}$As$_e$Te$_{0.01}$ | | | | | | |
|---|---|---|---|---|---|---|
| | x | e | Seebeck coefficient S ($\mu$V/K) | Electrical conductivity $\sigma$ (S/cm) | Thermal conductivity $\kappa$ (W/mK) | Dimensionless figure of merit ZT |
| Ex. 40 | 0.3 | 0.05 | -150 | 1370 | 1.44 | 0.70 |
| Ex. 41 | 0.3 | 0.125 | -173 | 1116 | 1.23 | 0.89 |
| Ex. 42 | 0.3 | 0.25 | -184 | 1046 | 1.14 | 1.02 |
| Ex. 43 | 0.4 | 0.001 | -138 | 1388 | 1.44 | 0.61 |
| Ex. 44 | 0.4 | 0.05 | -160 | 1098 | 1.22 | 0.76 |
| Ex. 45 | 0.4 | 0.125 | -176 | 958 | 1.09 | 0.89 |
| Ex. 46 | 0.4 | 0.25 | -184 | 952 | 1.07 | 0.99 |
| Ex. 47 | 0.6 | 0.001 | -159 | 1001 | 1.13 | 0.75 |
| Ex. 48 | 0.6 | 0.05 | -170 | 900 | 1.03 | 0.84 |
| Ex. 49 | 0.6 | 0.125 | -177 | 851 | 0.97 | 0.91 |
| Ex. 50 | 0.6 | 0.25 | -181 | 847 | 0.97 | 0.94 |
| Ex. 51 | 1.0 | 0.001 | -182 | 725 | 0.87 | 0.91 |
| Ex. 52 | 1.0 | 0.05 | -182 | 726 | 0.87 | 0.91 |
| Ex. 53 | 1.0 | 0.125 | -182 | 727 | 0.87 | 0.91 |
| Ex. 54 | 1.0 | 0.25 | -182 | 725 | 0.88 | 0.90 |
| Ex. 55 | 1.5 | 0.001 | -187 | 602 | 0.84 | 0.83 |
| Ex. 56 | 1.5 | 0.05 | -187 | 603 | 0.85 | 0.82 |
| Ex. 57 | 1.5 | 0.25 | -187 | 605 | 0.90 | 0.77 |
| Ex. 58 | 1.74 | 0.001 | -189 | 550 | 0.87 | 0.74 |
| Ex. 59 | 1.74 | 0.05 | -189 | 551 | 0.89 | 0.73 |
| Ex. 60 | 1.74 | 0.25 | -189 | 552 | 0.99 | 0.66 |

As indicated in Table 3, within the composition range of $0.0 \leq x \leq 1.74$, when the value of e is in the composition range of $0.001 \leq e \leq 0.25$, n-type thermoelectric conversion properties were exhibited in which the Seebeck coefficient S is negative. In addition, the thermoelectric figure of merit ZT in this case was high enough to exceed the thermoelectric figure of merit ZT of the comparative examples 2 and 14. Furthermore, Mg$_{3+m}$Sb$_x$Bi$_{1.99-x-e}$As$_e$Te$_{0.01}$ not containing one of Sb and Bi showed the high thermoelectric figure of merit ZT substantially equal to or higher than the thermoelectric figure of merit ZT of the comparative example 2 not containing As and satisfying e = 0. For example, in Table 3, the examples 31 to 34 that satisfy x = 0.0 and the example 60 that satisfy x = 1.74 showed the high thermoelectric figure of merit ZT substantially equal to or higher than the thermoelectric figure of merit ZT of the comparative example 2. Furthermore, in the examples 35 to 50 in which the value of x satisfies $0.2 \leq x \leq 0.6$, the thermoelectric figure of merit ZT increases as the value of e increases within the range of $0.001 \leq e \leq 0.25$. Tables 2 and 3 indicate the results of the respective cases in which one of P and As is contained. When a crystalline material contains both P and As, a portion of Bi may be replaced by both. In such a case, the crystalline material may be represented by the composition of Mg$_{3+m}$Sb$_x$Bi$_{1.99-x-e1-e2}$P$_{e1}$As$_{e2}$Te$_{0.01}$. In this case, the relation of e = e1 + e2 holds. In this case, it is also understood that n-type thermoelectric conversion properties in which the Seebeck coefficient S is negative are exhibited when the value of e is within the composition range of $0.001 \leq e \leq 0.25$ with the composition range of the value of x being $0.0 \leq x \leq 1.74$. In addition, it is understood that the thermoelectric figure of merit ZT is higher in this case than in the case where e = 0 or e = 0.5 is satisfied.

(EXAMPLES 61 to 63)

The thermoelectric conversion properties of Mg$_{3+m}$Sb$_x$Bi$_{1.99-x-e1-e2}$P$_{e1}$As$_{e2}$Te$_{0.01}$ at 330 K were predicted as

those of $Mg_{3+m}Sb_xBi_{1.99-x-e}P_eTe_{0.01}$. Table 4 shows the calculated values.

[Table 4]

| | | | | | | | |
|---|---|---|---|---|---|---|---|
| $Mg_{3+m}Sb_xBi_{1.99-x-e1-e2}P_{e1}As_{e2}Te_{0.01}$ | | | | | | | |
| | x | e1 | e2 | Seebeck coefficient | Electrical conductivity | Thermal conductivity | Dimensionless figure of merit |
| | | | | S ($\mu$V/K) | $\sigma$ (S/cm) | $\kappa$ (W/mK) | ZT |
| Com. Ex. 2 | 0.0 | 0.0 | 0.0 | -127 | 2188 | 2.06 | 0.56 |
| Ex. 61 | 0.0 | 0.0625 | 0.0625 | -131 | 2178 | 1.88 | 0.66 |
| Ex. 62 | 0.0 | 0.125 | 0.125 | -113 | 2493 | 2.12 | 0.50 |
| Ex. 63 | 1.74 | 0.125 | 0.125 | -189 | 552 | 0.99 | 0.66 |

As indicated in Table 4, when the value of x satisfies $0.0 \leq x \leq 1.74$ and the condition of $0.001 \leq e1+e2 \leq 0.25$ is satisfied, the crystalline material exhibited n-type thermoelectric conversion properties in which the Seebeck coefficient S is negative. In addition, the thermoelectric figure of merit ZT in this case was substantially equal to or higher than the thermoelectric figure of merit ZT of the comparative example 2. The thermoelectric figures of merit ZT indicated in Table 4 were substantially equal to the thermoelectric figures of merit ZT indicated in Tables 2 and 3. In particular, the example 61, which satisfies x = 0.0 and e1 + e2 = 0.125, and the example 63, which satisfies x = 1.74 and e1 + e2 = 0.25, showed thermoelectric figures of merit ZT that exceed the thermoelectric figure of merit ZT of a case not containing P or As.

(EXAMPLES 64 to 71)

A crystalline material having a composition of $Mg_{3+m}Sb_{1.0}Bi_{0.75-f}As_{0.25}Te_f$ can be produced, for example, as follows. First, elemental Mg, Sb, Bi, Te, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture was put into a graphite mold and sintered under an argon atmosphere using a spark plasma sintering technique to provide a cylindrical compact. In this way, the crystalline material having the composition of $Mg_{3+m}Sb_{1.0}Bi_{0.75-f}As_{0.25}Te_f$ based on $Mg_3(Sb,Bi)_2$ can be produced.

Referring to FIG. 3, the crystalline material having the composition of $Mg_{3+m}Sb_{1.0}Bi_{0.75-f}As_{0.25}Te_f$ has defects in which some of the sites C3 composed of at least one selected from the group consisting of Sb and Bi are replaced by As and Te. These defects are similar in pattern to the defects of the above-described crystalline material having the composition of $Mg_{3+m}Sb_xBi_{1.99-x-e}As_eTe_{0.01}$. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant of the crystal structure. The peaks of the X-ray diffraction pattern shift to the low-angle side as the lattice constant increases, and the peaks of the X-ray diffraction patterns shift to the high-angle side as the lattice constant decreases.

The stable composition range of the crystalline material having the composition of $Mg_{3+m}Sb_{1.0}Bi_{0.75-f}As_{0.25}Te_f$ is determined by using the same method as the method of determining the stable composition range of the above-described $Mg_{3+m-a-b}A_aB_bD_{2-e-f}E_eF_f$ crystalline material. The crystalline material is represented by the formula (1) in which the value of each of a and b is 0, D is Sb and Bi, E is As, the value of e is 0.25, F is Te, and the value of f satisfies $0.0 \leq f \leq 0.06$ with reference to PTL 1. In this crystalline material, the value of a is within the stable composition range of $0.0 \leq a \leq 0.04$. The value of b is within the stable composition range derived with reference to PTL 1. In this crystalline material, the value of m is $-0.1 \leq m \leq 0.4$ with reference to PTL 2. Furthermore, in this crystalline material, when E is As, the value of e is within the composition range obtained from the results showing the thermoelectric conversion properties of the crystalline material having the composition of $Mg_{3+m}Sb_xBi_{1.99-x-e}As_eTe_{0.01}$ indicated in Table 3. In this composition range, the value of e satisfies $0.001 \leq e \leq 0.25$ with the value of x being $0.0 \leq x \leq 1.74$. Furthermore, the composition ratio of Sb and Bi represented by the value of x is within the composition range indicated in Table 3.

The thermoelectric conversion properties of $Mg_{3+m}Sb_{1.0}Bi_{0.75-f}As_{0.25}Te_f$ at 330 K were predicted as those of $Mg_{3+m}Sb_xBi_{1.99-x-e}P_eTe_{0.01}$. Table 5 shows the calculated values.

[Table 5]

| | f | Seeteck coefficient S ($\mu$V/K) | Electrical conductivity $\sigma$ (S/cm) | Thermal conductivity $\kappa$ (W/mK) | Dimensionless figure of merit ZT |
|---|---|---|---|---|---|
| Com. Ex. 15 | 0.0 | -568 | 3 | 0.49 | 0.06 |
| Ex. 64 | 0.0001 | -552 | 9 | 0.49 | 0.18 |
| Ex. 65 | 0.0005 | -428 | 41 | 0.50 | 0.50 |
| Ex. 66 | 0.001 | -370 | 81 | 0.52 | 0.70 |
| Ex. 67 | 0.005 | -236 | 384 | 0.68 | 1.04 |
| Ex. 68 | 0.01 | -182 | 725 | 0.88 | 0.90 |
| Ex. 69 | 0.02 | -133 | 1316 | 1.26 | 0.61 |
| Ex. 70 | 0.04 | -91 | 2286 | 1.98 | 0.32 |
| Ex. 71 | 0.06 | -71 | 3098 | 2.65 | 0.20 |

$Mg_{3+m}Sb_{1.0}Bi_{0.75-f}As_{0.25}Te_f$

As indicated in Table 5, within the composition range of $0.0001 \leq f \leq 0.06$, n-type thermoelectric conversion properties were exhibited in which the value of S is negative, and the thermoelectric figure of merit ZT exceeded the thermoelectric figure of merit ZT of the comparative example 15.

(EXAMPLES 72 to 79)

A crystalline material having a composition of $Mg_{3+m}Sb_{1.0}Bi_{0.75-f}As_{0.25}Se_f$ can be produced, for example, as follows. First, elemental Mg, Sb, Bi, Se, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of $Mg_{3+m}Sb_{1.0}Bi_{0.75-f}As_{0.25}Se_f$ based on $Mg_3(Sb,Bi)_2$ can be produced.

Referring to FIG. 3, the crystalline material having the composition of $Mg_{3+m}Sb_{1.0}Bi_{0.75-f}As_{0.25}Se_f$ has defects in which some of the sites C3 composed of at least one selected from the group consisting of Sb and Bi are replaced by As and Se. These defects are similar in pattern to the defects of the above-described crystalline material having the composition of $Mg_{3+m}Sb_xBi_{1.99-x-e}As_eTe_{0.01}$ and the above-described crystalline material having the composition of $Mg_{3+m}Sb_{1.0}Bi_{0.75-f}As_{0.25}Te_f$. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in FIG. 2. The shift in the peaks found in the X-ray diffraction pattern results from the change in the lattice constant. The peaks of the X-ray diffraction pattern shift to the low-angle side as the lattice constant increases, and the peaks of the X-ray diffraction pattern shift to the high-angle side as the lattice constant decreases.

The stable composition range of the crystalline material having the composition of $Mg_{3+m}Sb_{1.0}Bi_{0.75-f}As_{0.25}Se_f$ is determined by using the same method as the method of determining the stable composition range of the above-described $Mg_{3+m-a-b}A_aB_bD_{2-e-f}E_eF_f$ crystalline material. The crystalline material is represented by the formula (1) in which the value of each of a and b is 0, D is Sb and Bi, E is As, the value of e is 0.25, F is Se, and the value of f is $0.0 \leq f \leq 0.06$ with reference to PTL 1. The crystalline material in which Bi is replaced by Se, which is homologous with Te, can exhibit n-type thermoelectric conversion properties. In this crystalline material, the value of a is within the stable composition range of $0.0 \leq a \leq 0.04$. The value of b is within the stable composition range derived with reference to PTL 1. The value of m is $-0.1 \leq m \leq 0.4$ with reference to PTL 2. Furthermore, when E is As, the value of e is within the composition range obtained from the results showing the thermoelectric conversion properties of the crystalline material having the composition of $Mg_{3+m}Sb_xBi_{1.99-x-e}As_eTe_{0.01}$ indicated in Table 3. In the composition range, the value of e satisfies the condition of $0.001 \leq e \leq 0.25$, within $0.0 \leq x \leq 1.74$. Furthermore, the composition ratio of Sb and Bi indicated from the value of x is within the composition range obtained from the results in Table 3.

The thermoelectric conversion properties of $Mg_{3+m}Sb_{1.0}Bi_{0.75-f}As_{0.25}Se_f$ at 330 K were predicted as those of $Mg_{3+m}Sb_xBi_{1.99-x-e}P_eTe_{0.01}$. Table 6 shows the calculated values.

[Table 6]

| $Mg_{3+m}Sb_{1.0}Bi_{0.75-f}As_{0.25}Se_f$ | | | | | |
|---|---|---|---|---|---|
| | f | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | -568 | 3 | 0.49 | 0.06 |
| Ex. 72 | 0.0001 | -585 | 5 | 0.49 | 0.11 |
| Ex. 73 | 0.0005 | -497 | 18 | 0.49 | 0.30 |
| Ex. 74 | 0.001 | -440 | 36 | 0.50 | 0.46 |
| Ex. 75 | 0.005 | -304 | 173 | 0.57 | 0.93 |
| Ex. 76 | 0.01 | -247 | 337 | 0.66 | 1.04 |
| Ex. 77 | 0.02 | -193 | 639 | 0.83 | 0.95 |
| Ex. 78 | 0.04 | -142 | 1171 | 1.16 | 0.67 |
| Ex. 79 | 0.06 | -116 | 1635 | 1.48 | 0.49 |

As indicated in Table 6, within the range of $0.0001 \leq f \leq 0.06$, n-type thermoelectric conversion properties were exhibited in which the value of S is negative and the thermoelectric figure of merit ZT was high enough to exceed the thermoelectric figure of merit ZT of the comparative example 15. Tables 5 and 6 show the results of the respective cases in which one of Te and Se is contained as F. When Te and Se are both contained as F, a portion of Bi may be replaced by both Te and Se. In such a case, the crystalline material has the composition of $Mg_{3+m}Sb_{1.0}Bi_{0.75-f1-f2}As_{0.25}Te_{f1}Se_{f2}$. Here, the relation of f = f1 + f2 holds. In this case, it is also understood that, when the value of f is in the composition range of $0.0001 \leq f \leq 0.06$, n-type properties in which the Seebeck coefficient S is negative are exhibited and the thermoelectric figure of merit ZT is high enough to exceed the thermoelectric figure of merit ZT in the case where f = 0 and f > 0.06.

The results indicated in Tables 2 to 6 indicate that the composition of the crystalline material can be represented by $Mg_{3+m}Sb_xBi_{1.99-x-e1-e2-f1-f2}P_{e1}As_{e2}Te_{f1}Se_{f2}$. In such a case, when the value of x is within the composition range of $0.0 \leq x \leq 1.74$, $0.001 \leq e \leq 0.25$ may be satisfied and $0.0001 \leq f \leq 0.06$ may be satisfied. It is noted that e = e1 + e2 holds, and e = f1 + f2 holds.

(EXAMPLES 80 to 82)

The thermoelectric conversion properties of $Mg_{3+m}Sb_{1.0}Bi_{0.75-f1-f2}As_{0.25}Te_{f1}Se_{f2}$ at 330 K were predicted as those of $Mg_{3+m}Sb_xBi_{1.99-x-e}P_eTe_{0.01}$. Table 7 shows the calculated values.

[Table 7]

| $Mg_{3+m}Sb_{1.0}Bi_{0.75-f1-f2}As_{0.25}Te_{f1}Se_{f2}$ | | | | | | |
|---|---|---|---|---|---|---|
| | f1 | f2 | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | 0.0 | -568 | 3 | 0.49 | 0.06 |
| Ex. 80 | 0.00005 | 0.00005 | -570 | 6.8 | 0.49 | 0.15 |
| Ex. 81 | 0.005 | 0.005 | -208 | 537 | 0.77 | 1.00 |
| Ex. 82 | 0.03 | 0.03 | -87 | 2418 | 2.08 | 0.29 |

As indicated in Table 7, within the range of $0.0001 \leq f1 + f2 \leq 0.06$, n-type thermoelectric conversion properties were exhibited in which the Seebeck coefficient S is negative, and the thermoelectric figures of merit ZT were high enough to exceed the thermoelectric figure of merit ZT of the comparative example 15.

(EXAMPLES 83 to 89)

A crystalline material having n-type thermoelectric conversion properties in which the value of S is negative may be obtained by addition of Y, Sc, La or Ce.

A crystalline material having a composition of $Mg_{3+m-a}Y_aSb_{1.0}Bi_{0.75}As_{0.25}$ can be produced, for example, as follows. First, elemental Mg, Y, Sb, Bi, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of $Mg_{3+m-a}Y_aSb_{1.0}Bi_{0.75}As_{0.25}$ based on $Mg_3(Sb,Bi)_2$ can be produced.

Referring to FIG. 3, the crystalline material having the composition of $Mg_{3+m-a}Y_aSb_{1.0}Bi_{0.75}As_{0.25}$ has defects in which some of the Mg sites C1 are replaced by Y. In addition, the crystalline material has defects in which some of the sites C3 composed of at least one selected from the group consisting of Sb and Bi are replaced by As. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the peaks of the X-ray diffraction pattern shift to the high-angle side as the lattice constant decreases.

The stable composition range of the crystalline material having the composition of $Mg_{3+m-a}Y_aSb_{1.0}Bi_{0.75}As_{0.25}$ is determined by using the same method as the method of determining the stable composition range of the above-described $Mg_{3+m-a-b}A_aB_bD_{2-e-f}E_eF_f$ crystalline material. The crystalline material having the composition of $Mg_{3+m-a}Y_aSb_{1.0}Bi_{0.75}As_{0.25}$ is represented by the formula (1) in which A is Y, the value of a satisfies the condition of $0.0 \leq a \leq 0.04$ with reference to NPL 7, and the value of b is 0. In addition, D is Sb and Bi, E is As, the value of e is 0.25, and the value of f is 0. When Mg is replaced by Y, n-type thermoelectric conversion properties can be exhibited.

The method of determining the stable composition range of the crystalline material having the composition of $Mg_{3+m}Sb_xBi_{1.99-x-e}As_eTe_{0.01}$ was used for the crystalline material that contains A in the formula (1). As a result, it was evaluated that the defect generation energy of the crystalline material in the case where A is Sc and in the case where A is La is lower than that in the case where A is Y and thus the crystalline material can be stably synthesized. Furthermore, it is understood from NPL 9 that, when A is Ce, the crystalline material can be more stably synthesized than when A is La. This suggests that the stable composition range of the value of a is the narrowest when A is Y. Thus, the stable composition range of the value of a that allows stable synthesis of the crystalline material even when any one of Sc, Y, La, and Ce is selected as A was set at $0.0 \leq a \leq 0.04$, which corresponds to the narrowest stable composition range in the case where A is Y. The value of b of the crystalline material having the composition of $Mg_{3+m-a}Y_aSb_{1.0}Bi_{0.75}As_{0.25}$ is within the stable composition range derived with reference to PTL 1. In the crystalline material, the value of m satisfies the condition of $-0.1 \leq m \leq 0.4$ with reference to PTL 2. Furthermore, in the crystalline material, when E is As, the value of e is within the composition range obtained from the results showing the thermoelectric conversion properties of the crystalline material having the composition of $Mg_{3+m}Sb_xBi_{1.99-x-e}As_eTe_{0.01}$ indicated in Table 3. In the composition range, within the range of $0.0 \leq x \leq 1.74$, the value of e satisfies the condition of $0.001 \leq e \leq 0.25$. In the crystalline material, the composition ratio of Sb and Bi represented by the value of x is within the composition range obtained from the results in Table 3. The crystalline material contains Y instead of Te and Se, and thus the value of f is within the composition range of $0.0 \leq f \leq 0.06$ referred to in PTL 1.

The thermoelectric conversion properties of $Mg_{3+m-a}Y_aSb_{1.0}Bi_{0.75}As_{0.25}$ at 330 K were predicted as those of $Mg_{3+m}Sb_xBi_{1.99-x-e}P_eTe_{0.01}$. Table 8 shows the calculated values.

[Table 8]

| $Mg_{3+m-a}Y_aSb_{1.0}Bi_{0.75}As_{0.25}$ | | | | | |
|---|---|---|---|---|---|
| | a | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | -568 | 3 | 0.49 | 0.06 |

(continued)

| Mg$_{3+m-a}$Y$_a$Sb$_{1.0}$Bi$_{0.75}$As$_{0.25}$ | | | | | |
|---|---|---|---|---|---|
| | a | Seebeck coefficient S ($\mu$V/K) | Electrical conductivity $\sigma$ (S/cm) | Thermal conductivity $\kappa$ (W/mK) | Dimensionless figure of merit ZT |
| Ex. 83 | 0.0001 | -482 | 22 | 0.49 | 0.34 |
| Ex. 84 | 0.0005 | -347 | 105 | 0.53 | 0.79 |
| Ex. 85 | 0.001 | -289 | 207 | 0.59 | 0.98 |
| Ex. 86 | 0.005 | -162 | 916 | 1.00 | 0.80 |
| Ex. 87 | 0.01 | -116 | 1635 | 1.48 | 0.49 |
| Ex. 88 | 0.02 | -78 | 2794 | 2.39 | 0.23 |
| Ex. 89 | 0.04 | -52 | 4622 | 4.02 | 0.10 |

As indicated in Table 8, within the range of $0.0001 \leq a \leq 0.04$, the thermoelectric figures of merit ZT were high enough to exceed the thermoelectric figure of merit ZT of the comparative example 15.

(EXAMPLES 90 to 96)

A crystalline material having a composition of Mg$_{3+m-a}$Sc$_a$Sb$_{1.0}$Bi$_{0.75}$As$_{0.25}$ can be produced, for example, as follows. First, elemental Mg, Sc, Sb, Bi, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture was put into a graphite mold and was sintered under an argon atmosphere using a spark plasma sintering technique to provide a cylindrical compact. In this way, the crystalline material having the composition of Mg$_{3+m-a}$Sc$_a$Sb$_{1.0}$Bi$_{0.75}$As$_{0.25}$ based on Mg$_3$(Sb,Bi)$_2$ can be produced.

Referring to FIG. 3, the crystalline material having the composition of Mg$_{3+m-a}$Sc$_a$Sb$_{1.0}$Bi$_{0.75}$As$_{0.25}$ has defects in which some of the Mg sites C1 are replaced by Sc. In addition, the crystalline material has defects in which some of the sites C3 composed of at least one selected from the group consisting of Sb and Bi are replaced by As. These defects may cause lattice deformation in the La$_2$O$_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the Mg$_3$(Sb,Bi)$_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the peaks of the X-ray diffraction patterns shift to the high-angle side as the lattice constant decreases.

The stable composition range of the crystalline material having the composition of Mg$_{3+m-a}$Sc$_a$Sb$_{1.0}$Bi$_{0.75}$As$_{0.25}$ is determined by using the same method as the method of determining the stable composition range of the above-described Mg$_{3+m-a-b}$A$_a$B$_b$D$_{2-e-f}$E$_e$F$_f$ crystalline material. The crystalline material having the composition of Mg$_{3+m-a}$Sc$_a$Sb$_{1.0}$Bi$_{0.75}$As$_{0.25}$ is represented by the formula (1) in which A is Sc, the value of a satisfies the condition of $0.0 \leq a \leq 0.04$, and the value of b is 0. In addition, D is Sb and Bi, E is As, the value of e is 0.25, and the value of f is 0. In the crystalline material, even when Mg is replaced by Sc, which is homologous with Y, n-type thermoelectric conversion properties can be exhibited. The value of a satisfies the condition of $0.0 \leq a \leq 0.03$ with reference to NPL 6. However, as described above, it is understood that, when A is Y, the stable composition range of the value of a is the narrowest. Thus, the stable composition range of the value of a that allows stable synthesis of the crystalline material even when any one of Sc, Y, La, and Ce is selected as A was set as $0.0 \leq a \leq 0.04$, which corresponds to the narrowest stable composition range in the case where A is Y.

In the crystalline material having the composition of Mg$_{3+m-a}$Sc$_a$Sb$_{1.0}$Bi$_{0.75}$As$_{0.25}$, the value of b is within the stable composition range derived with reference to PTL 1. The value of m satisfies the condition of $-0.1 \leq m \leq 0.4$ with reference to PTL 2. Furthermore, when E is As, the value of e is within the composition range obtained from the results showing the thermoelectric conversion properties of the crystalline material having the composition of Mg$_{3+m}$Sb$_x$Bi$_{1.99-x-e}$As$_e$Te$_{0.01}$ in Table 3. In the composition range, within the range of $0.0 \leq x \leq 1.74$, the value of e satisfies the condition of $0.001 \leq e \leq 0.25$. Furthermore, the composition ratio of Sb and Bi represented by the value of x is within the composition range obtained from the results in Table 3. The crystalline material contains Sc instead of Te or Se, and thus the value off satisfies the condition of $0.0 \leq f \leq 0.06$ referred to in PTL 1.

The thermoelectric conversion properties of $Mg_{3+m-a}Sc_aSb_{1.0}Bi_{0.75}As_{0.25}$ at 330 K were predicted as those of $Mg_{3+m}Sb_xBi_{1.99-x-e}P_eTe_{0.01}$. Table 9 shows the calculated values.

[Table 9]

| $Mg_{3+m-a}Sc_aSb_{1.0}Bi_{0.75}As_{0.25}$ | | | | | |
|---|---|---|---|---|---|
| | a | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | -568 | 3 | 0.49 | 0.06 |
| Ex. 90 | 0.0001 | -459 | 29 | 0.50 | 0.40 |
| Ex. 91 | 0.0005 | -323 | 140 | 0.55 | 0.87 |
| Ex. 92 | 0.001 | -266 | 273 | 0.62 | 1.02 |
| Ex. 93 | 0.005 | -142 | 1171 | 1.16 | 0.67 |
| Ex. 94 | 0.01 | -99 | 2053 | 1.80 | 0.37 |
| Ex. 95 | 0.02 | -65 | 3451 | 2.95 | 0.16 |
| Ex. 96 | 0.04 | -46 | 5705 | 5.06 | 0.08 |

As indicated in Table 9, within the range of $0.0001 \leq a \leq 0.04$, the thermoelectric figures of merit ZT were high enough to exceed the thermoelectric figure of merit ZT of the comparative example 15.

(EXAMPLES 97 to 103)

A crystalline material having a composition of $Mg_{3+m-a}La_aSb_{1.0}Bi_{0.75}As_{0.25}$ can be produced, for example, as follows. First, elemental Mg, La, Sb, Bi, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of $Mg_{3+m-a}La_aSb_{1.0}Bi_{0.75}As_{0.25}$ based on $Mg_3(Sb,Bi)_2$ can be produced.

Referring to FIG. 3, the crystalline material having the composition of $Mg_{3+m-a}La_aSb_{1.0}Bi_{0.75}As_{0.25}$ has defects in which some of the Mg sites C1 are replaced by La. In addition, the crystalline material has defects in which some of the sites C3 composed of at least one selected from the group consisting of Sb and Bi are replaced by As. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the peaks of the X-ray diffraction patterns shift to the high-angle side as the lattice constant decreases.

The stable composition range of the crystalline material having the composition of $Mg_{3+m-a}La_aSb_{1.0}Bi_{0.75}As_{0.25}$ is determined by using the same method as the method of determining the stable composition range of the above-described $Mg_{3+m-a-b}A_aB_bD_{2-e-f}E_eF_f$ crystalline material. The crystalline material having the composition of $Mg_{3+m-a}La_aSb_{1.0}Bi_{0.75}As_{0.25}$ is represented by the formula (1), in which A is La, the value of a satisfies the condition of $0.0 \leq a \leq 0.04$, the value of b is 0, D is Sb and Bi, E is As, the value of e is 0.25, and the value of f is 0. In this crystalline material, even when Mg is replaced by La, which is homologous with Y and Sc, n-type thermoelectric conversion properties can be exhibited. The value of a satisfies the condition of $0.0 \leq a \leq 0.03$ with reference to NPL 8. However, as described above, it is understood that, when A is Y, the stable composition range of the value of a is the narrowest. Thus, the stable composition range of the value of a that allows stable synthesis of the crystalline material even when any one of Sc, Y, La, and Ce is selected as A was set at $0.0 \leq a \leq 0.04$, which corresponds to the narrowest stable composition range in the case where A is Y.

In the crystalline material having the composition of $Mg_{3+m-a}La_aSb_{1.0}Bi_{0.75}As_{0.25}$, the value of b is within the stable composition range derived with reference to PTL 1. The value of m satisfies the condition of $-0.1 \leq m \leq 0.4$ with reference to PTL 2. Furthermore, when E is As, the value of e is within the composition range obtained from the results showing the thermoelectric conversion properties of the crystalline material having the composition of $Mg_{3+m}Sb_xBi_{1.99-x-e}As_eTe_{0.01}$ indicated in Table 3. In the composition range, within the range of $0.0 \leq x \leq 1.74$, the value of e satisfies the condition of $0.001 \leq e \leq 0.25$. Furthermore, the composition ratio of Sb and Bi represented by the value of x is within the composition range obtained from the results in Table 3. The crystalline material contains La instead of Te or Se, and thus the value of f is within the composition range of $0.0 \leq f \leq 0.06$ referred to in PTL 1.

The thermoelectric conversion properties of $Mg_{3+m-a}La_aSb_{1.0}Bi_{0.75}As_{0.25}$ at 330 K were predicted as those of $Mg_{3+m}Sb_xBi_{1.99-x-e}P_eTe_{0.01}$. Table 10 shows the calculated values.

[Table 10]

| $Mg_{3+m-a}La_aSb_{1.0}Bi_{0.75}As_{0.25}$ | | | | | |
|---|---|---|---|---|---|
| | a | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | -568 | 3 | 0.49 | 0.06 |
| Ex. 97 | 0.0001 | -459 | 29 | 0.50 | 0.40 |
| Ex. 98 | 0.0005 | -323 | 140 | 0.55 | 0.87 |
| Ex. 99 | 0.001 | -266 | 273 | 0.62 | 1.02 |
| Ex. 100 | 0.005 | -142 | 1171 | 1.16 | 0.67 |
| Ex. 101 | 0.01 | -99 | 2053 | 1.80 | 0.37 |
| Ex. 102 | 0.02 | -65 | 3451 | 2.95 | 0.16 |
| Ex. 103 | 0.04 | -46 | 5705 | 5.06 | 0.08 |

As indicated in Table 10, within the range of $0.0001 \leq a \leq 0.04$, the thermoelectric figures of merit ZT were high enough to exceed the thermoelectric figure of merit ZT of the comparative example 15.

(EXAMPLES 104 to 110)

A crystalline material having a composition of $Mg_{3+m-a}Ce_aSb_{1.0}Bi_{0.75}As_{0.25}$ can be produced, for example, as follows. First, elemental Mg, Ce, Sb, Bi, and As as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture i put into a graphite mold and sintered under an argon atmosphere using a spark plasma sintering technique to provide a cylindrical compact. In this way, the crystalline material having the composition of $Mg_{3+m-a}Ce_aSb_{1.0}Bi_{0.75}As_{0.25}$ based on $Mg_3(Sb,Bi)_2$ can be produced.

Referring to FIG. 3, the crystalline material having the composition of $Mg_{3+m-a}Ce_aSb_{1.0}Bi_{0.75}As_{0.25}$ has defects in which some of the Mg sites C1 are replaced by Ce. In addition, the crystalline material has defects in which some of the sites C3 composed of at least one selected from the group consisting of Sb and Bi are replaced by As. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the peaks of the X-ray diffraction patterns shift to the high-angle side as the lattice constant decreases.

The stable composition range of the crystalline material having the composition of $Mg_{3+m-a}Ce_aSb_{1.0}Bi_{0.75}As_{0.25}$ is determined by using the same method as the method of determining the stable composition range of the above-described $Mg_{3+m-a-b}A_aB_bD_{2-e-f}E_eF_f$ crystalline material. The crystalline material having the composition of $Mg_{3+m-a}Ce_aSb_{1.0}Bi_{0.75}As_{0.25}$ is represented by the formula (1) in which A is Ce, the value of a satisfies the condition of $0.0 \leq a \leq 0.04$, and the value of b is 0. In addition, D is Sb and Bi, E is As, the value of e is 0.25, and the value of f is 0.

In this crystalline material, even when Mg is replaced by Ce, which is homologous with Y, Sc, and La, n-type thermoelectric conversion properties can be exhibited. Referring to NPL 9, it is understood that the crystalline material can be more stably synthesized when A is Ce than when A is La. Thus, it is understood that the stable composition range relating to the value of a in the case where A is Ce is broader than $0.0 \leq a \leq 0.03$, which is the range of the value of a in the case where A is La referred to in NPL 8. In contrast, as described above, it is understood that the stable composition range of the value of a is the narrowest when A is Y. Thus, the stable composition range of the value of a that allows stable synthesis of the crystalline material even when any one of Sc, Y, La, and Ce is selected as A was set at $0.0 \leq a \leq 0.04$, which corresponds to the narrowest stable composition range in the case where A is Y.

In the crystalline material having the composition of $Mg_{3+m-a}Ce_aSb_{1.0}Bi_{0.75}As_{0.25}$, the value of b is in the stable composition range derived with reference to PTL 1. The value of m satisfies the condition of $-0.1 \leq m \leq 0.4$ with reference to PTL 2. Furthermore, when E is As, the value of e is within the composition range obtained from the results showing the thermoelectric conversion properties of the crystalline material having the composition of $Mg_{3+m}Sb_xBi_{1.99-x-e}As_eTe_{0.01}$ indicated in Table 3. In this composition range, within the range of $0.0 \leq x \leq 1.74$, the value of e satisfies the condition of $0.001 \leq e \leq 0.25$. Furthermore, the composition ratio of Sb and Bi represented by the value of x is also within the composition range obtained from the results in Table 3. This crystalline material contains Ce instead of Te or Se, and thus the value of f satisfies the condition of $0.0 \leq f \leq 0.06$ referred to in PTL 1.

The thermoelectric conversion properties of $Mg_{3+m-a}Ce_aSb_{1.0}Bi_{0.75}As_{0.25}$ at 330 K were predicted as those of $Mg_{3+m}Sb_xBi_{1.99-x-e}P_eTe_{0.01}$. Table 11 shows the calculated values.

[Table 11]

| $Mg_{3+m-a}Ce_aSb_{1.0}Bi_{0.75}As_{0.25}$ | | | | | |
|---|---|---|---|---|---|
| | a | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | -568 | 3 | 0.49 | 0.06 |
| Ex. 104 | 0.0001 | -459 | 32 | 0.50 | 0.43 |
| Ex. 105 | 0.0005 | -3133 | 157 | 0.56 | 0.91 |
| Ex. 106 | 0.001 | -256 | 305 | 0.64 | 1.03 |
| Ex. 107 | 0.005 | -134 | 1292 | 1.24 | 0.62 |
| Ex. 108 | 0.01 | -92 | 2248 | 1.95 | 0.32 |
| Ex. 109 | 0.02 | -61 | 3758 | 3.23 | 0.14 |
| Ex. 110 | 0.04 | -44 | 6248 | 5.57 | 0.07 |

As indicated in Table 11, within the range of $0.0001 \leq a \leq 0.04$, the thermoelectric figures of merit ZT were high enough to exceed the thermoelectric figure of merit ZT of the comparative example 15.

Tables 8 to 11 indicate the results of the respective cases in which the formula (1) contains one of Y, Sc, La, and Ce as F. When the crystalline material contains multiple kinds of elements selected from Y, Sc, La, and Ce, a portion of Mg may be replaced by the multiple kinds of elements. For example, a crystalline material having the composition of $Mg_{3+m-a1-a2-a3-a4}Y_{a1}Sc_{a2}La_{a3}Ce_{a4}Sb_{1.0}Bi_{0.75}As_{0.25}$ can be provided. In such a case, the relation of a = a1 + a2 + a3 + a4 holds. In this case, it is also understood that, when the condition of $0.0001 \leq a \leq 0.04$ is satisfied, n-type thermoelectric conversion properties in which the Seebeck coefficient S is negative are exhibited and the thermoelectric figure of merit ZT is higher than that in the case where a = 0 and a > 0.04.

The results indicated in Tables 2 to 4 and 8 to 11 indicate that a crystalline material having the composition of $Mg_{3+m-a1-a2-a3-a4}Y_{a1}Sc_{a2}La_{a3}Ce_{a4}Sb_xBi_{1.99-x-e1-e2}P_{e1}As_{e2}$ can be provided. In this case, within the range of $0.0 \leq x \leq 1.74$, the value of e that satisfies the relation of e = e1 + e2 may satisfy the condition of $0.001 \leq e \leq 0.25$ and the value of a that satisfies the relation of a = a1 + a2 + a3 + a4 may satisfy the condition of $0.0001 \leq a \leq 0.04$.

(EXAMPLES 111 to 113)

The thermoelectric conversion properties of $Mg_{3+m-a1-a2}Y_{a1}Sc_{a2}Sb_{1.0}Bi_{0.75}As_{0.25}$ at 330 K were predicted as those of $Mg_{3+m}Sb_xBi_{1.99-x-e}P_eTe_{0.01}$. Table 12 shows the calculated values.

[Table 12]

| $Mg_{3+m-a1-a2}Y_{a1}Sc_{a2}Sb_{1.0}Bi_{0.75}As_{0.25}$ | | | | | | |
|---|---|---|---|---|---|---|
| | a1 | a2 | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | 0.0 | -568 | 3 | 0.49 | 0.06 |
| Ex. 111 | 0.00005 | 0.00005 | -470 | 25 | 0.49 | 0.37 |
| Ex. 112 | 0.0005 | 0.0005 | -276 | 240 | 0.60 | 1.00 |
| Ex. 113 | 0.02 | 0.02 | -48 | 5168 | 4.54 | 0.09 |

As indicated in Table 12, within the range of $0.0001 \leq a1 + a2 \leq 0.04$, the thermoelectric figures of merit ZT were high enough to exceed the thermoelectric figure of merit ZT of the comparative example 15.

Tables 5 and 6 indicate the results of the respective cases in which the formula (1) contains one of Te and Se as F. In contrast, Tables 8 to 11 indicate the results of the respective cases in which the formula (1) contains one of Y, Sc, La, and Ce as A. When the formula (1) contains both F and A, a crystalline material having the composition of $Mg_{3+m-a1-a2-a3-a4}Y_{a1}Sc_{a2}La_{a3}Ce_{a4}Sb_{1.0}Bi_{0.75-f1-f2}As_{0.25}Te_{f1}Se_{f2}$ can be provided. In this case, the relations of $a = a1 + a2 + a3 + a4$ and $f = f1 + f2$ hold. It is understood that, in such a case, within the composition range of $0.0001 \leq a + f \leq 0.06$, n-type thermoelectric conversion properties in which the Seebeck coefficient S is negative are exhibited and the thermoelectric figure of merit ZT is higher than that in the case where $a = 0$ and $a > 0.04$.

The results indicated in Tables 2 to 12 indicate that a crystalline material having the composition of $Mg_{3+m-a1-a2-a3-a4}Y_{a1}Sc_{a2}La_{a3}Ce_{a4}Sb_xBi_{1.99-x-e1-e2-f1-f2}P_{e1}As_{e2}Te_{f1}Se_{f2}$ can be provided. It is understood that, in this case, when the value of x satisfies $0.0 \leq x \leq 1.74$, the value of e that satisfies the relation of $e = e1 + e2$ may satisfy the condition of $0.001 \leq e \leq 0.25$. Furthermore, it is understood that the sum of the value of a that satisfies the relation of $a = a1 + a2 + a3 + a4$ and the value of f that satisfies the relation of $f = f1 + f2$ may satisfy the condition of $0.0001 \leq a + f \leq 0.06$.

(EXAMPLES 114 to 116)

The thermoelectric conversion properties of $Mg_{3+m-a1}Y_{a1}Sb_{1.0}Bi_{0.75-f1}As_{0.25}Te_{f1}$ at 330 K were predicted as those of $Mg_{3+m}Sb_xBi_{1.99-x-e}P_eTe_{0.01}$. Table 13 shows the calculated values.

[Table 13]

| $Mg_{3+m-a1}Y_{a1}Sb_{1.0}Bi_{0.75-f1}As_{0.25}Te_{f1}$ | | | | | | |
|---|---|---|---|---|---|---|
| | a1 | f1 | Seebeck coefficient S ($\mu$V/K) | Electrical conductivity $\sigma$ (S/cm) | Thermal conductivity $\kappa$ (W/mK) | Dimensionless figure of merit ZT |
| Com. Ex. 15 | 0.0 | 0.0 | -568 | 3 | 0.49 | 0.06 |
| Ex. 114 | 0.00005 | 0.00005 | -511 | 15 | 0.49 | 0.27 |
| Ex. 115 | 0.005 | 0.005 | -140 | 1208 | 1.19 | 0.66 |
| Ex. 116 | 0.03 | 0.03 | -51 | 4746 | 4.14 | 0.10 |

As indicated in Table 13, within the range of $0.0001 \leq a1 + f1 \leq 0.06$, the thermoelectric figures of merit ZT were high enough to exceed the thermoelectric figure of merit ZT of the comparative example 15.

(EXAMPLES 3, 117, and 118)

A crystalline material having a composition of $Mg_{3+m-b}Mn_bBi_{1.865}P_{0.125}Te_{0.01}$ can be produced, for example, as follows. First, elemental Mg, Mn, Bi, P, and Te as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of $Mg_{3+m-b}Mn_bBi_{1.865}P_{0.125}Te_{0.01}$ based on $Mg_3(Sb,Bi)_2$ can be produced.

Referring to FIG. 3, the crystalline material having the composition of $Mg_{3+m-b}Mn_bBi_{1.865}P_{0.125}Te_{0.01}$ has defects in which some of the Mg sites C2 are replaced by Mn. In addition, the crystalline material has defects in which some of the sites C3 composed of at least one selected from the group consisting of Sb and Bi are replaced by P. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material relative to the intensity peaks of the X-ray diffraction pattern of the $Mg_3(Sb,Bi)_2$ crystalline material indicated in Fig. 2. The shift in the peaks found in the X-ray diffraction pattern results from the change in the lattice constant. The peaks of the X-ray diffraction pattern shift to the low-angle side as the lattice constant increases, and the peaks of the X-ray diffraction patterns shift to the high-angle side as the lattice constant decreases.

The stable composition range of the crystalline material having the composition of $Mg_{3+m-b}Mn_bBi_{1.865}P_{0.125}Te_{0.01}$ is determined by using the same method as the method of determining the stable composition range of the above-described $Mg_{3+m-a-b}A_aB_bD_{2-e-f}E_eF_f$ crystalline material. The crystalline material having the composition of $Mg_{3+m-b}Mn_bBi_{1.865}P_{0.125}Te_{0.01}$ is represented by the formula (1) in which the value of a is 0, B is Mn, the value of b satisfies the condition of $0.0 \leq b \leq 0.48$ with reference to PTL 1, and D is Bi. In addition, E is P, the value of e is 0.125, F is Te, and the value of f is 0.01. In this crystalline material, the value of a is within the stable composition range of $0.0 \leq a \leq 0.04$. In this crystalline material, the value of m satisfies the condition of $-0.1 \leq m \leq 0.4$ with reference to PTL 2. In addition, in this crystalline material, when E is P, the value of e is within the composition range obtained from the results showing the thermoelectric conversion properties of the crystalline material having the composition of $Mg_{3+m}Sb_xBi_{1.99-x-e}P_eTe_{0.01}$ indicated in Table 2. In this composition range, the value of e satisfies $0.001 \leq e \leq 0.25$ with the value of x being $0.0 \leq x \leq 1.74$. Furthermore, the composition ratio of Sb and Bi represented by the value of x is within the composition range obtained from the results indicated in Table 2. In addition, in this crystalline material, the value of a is 0, and thus the value of f is within the stable composition range of $0.0001 \leq f \leq 0.06$ obtained from the results in Table 5.

The thermoelectric conversion properties of $Mg_{3+m-b}Mn_bBi_{1.865}P_{0.125}Te_{0.01}$ at 330 K were predicted as those of $Mg_{3+m}Sb_xBi_{1.99-x-e}P_eTe_{0.01}$. Table 14 shows the calculated values.

[Table 14]

| $Mg_{3+m-b}Mn_bBi_{1.865}P_{0.125}Te_{0.01}$ | | | | | |
|---|---|---|---|---|---|
| | b | Seebeck coefficient S ($\mu$V/K) | Electrical conductivity $\sigma$ (S/cm) | Thermal conductivity $\kappa$ (W/mK) | Dimensionless figure of merit ZT |
| Ex. 3 | 0.0 | -127 | 2246 | 1.93 | 0.62 |
| Ex. 117 | 0.125 | -122 | 2078 | 2.00 | 0.51 |
| Ex. 118 | 0.25 | -122 | 2152 | 2.05 | 0.52 |
| Com. Ex. 16 | 0.375 | -109 | 2428 | 2.19 | 0.44 |

As indicated in Table 14, within the composition range of $0.0 \leq b \leq 0.25$, n-type thermoelectric conversion properties were exhibited in which the Seebeck coefficient S is negative, and the thermoelectric figure of merit ZT was high enough to exceed the thermoelectric figure of merit ZT of the comparative example 16.

(EXAMPLES 34, 119, and 120)

A crystalline material having a composition of $Mg_{3+m-b}Zn_bBi_{1.74}As_{0.25}Te_{0.01}$ can be produced, for example, as follows. First, elemental Mg, Zn, Bi, As, and Te as materials are weighed to be in a desired composition ratio and sealed in a stainless-steel container together with stainless-steel balls under an argon atmosphere, and the materials are pulverized and mixed by a planetary ball milling technique to provide a powder mixture. The generated powder mixture is put into a graphite mold and sintered under an argon atmosphere using a spark plasma sintering technique to provide a cylindrical compact. In this way, the crystalline material having the composition of $Mg_{3+m-b}Zn_bBi_{1.74}As_{0.25}Te_{0.0}$ based on $Mg_3(Sb,Bi)_2$ can be produced.

Referring to FIG. 3, the crystalline material having the composition represented by $Mg_{3+m-b}Zn_bBi_{1.74}As_{0.25}Te_{0.01}$ has defects in which some of the Mg sites C2 are replaced by Zn. This crystalline material has defects in which some of the sites C3 composed of at least one selected from the group consisting of Sb and Bi are replaced by As. These defects may cause lattice deformation in the $La_2O_3$-type crystal structure. This lattice deformation changes the lattice constant of at least a portion of the crystal. Thus, it is predicted that there is a shift in the intensity peaks of the X-ray diffraction pattern of the thermoelectric conversion material having this composition relative to the intensity peaks of the X-ray diffraction pattern of the $Mg_3(Sb,Bi)_2$ crystalline material indicated in FIG. 2. The shift in the peaks found in the X-ray diffraction pattern results from the change in the lattice constant. The peaks of the X-ray diffraction pattern shift to the low-angle side as the lattice constant increases, and the peaks of the X-ray diffraction patterns shift to the high-angle side as the lattice constant decreases.

The stable composition range of the crystalline material having the composition of $Mg_{3+m-b}Zn_bBi_{1.74}As_{0.25}Te_{0.01}$ is determined by using the same method as the method of determining the stable composition range of the above-described $Mg_{3+m-a-b}A_aB_bD_{2-e-f}E_eF_f$ crystalline material. The crystalline material having the composition of $Mg_{3+m-b}Zn_bBi_{1.74}As_{0.25}Te_{0.01}$ is represented by the formula (1), in which the value of a is 0, B is Zn, the value of b satisfies the condition of $0.0 \leq b \leq 0.48$ with reference to PTL 1, and D is Bi. In addition, E is As, the value of e is 0.25, F is Te, and the value of f is 0.01. In this crystalline material, the value of a is within the stable composition range of $0.0 \leq a \leq 0.04$. In this crystalline material, the value of m satisfies the condition of $-0.1 \leq m \leq 0.4$ with reference to PTL 2. In addition, in this crystalline material, when E is As, the value of e is within the composition range obtained from the results showing the thermoelectric conversion properties of the crystalline material having the composition of $Mg_{3+m}Sb_xBi_{1.99-x-e}As_eTe_{0.01}$ indicated in Table 3. In this composition range, within the range of $0.0 \leq x \leq 1.74$, the value of e satisfies the condition of $0.001 \leq e \leq 0.25$. Furthermore, the composition ratio of Sb and Bi represented by the value of x is within the composition range obtained from the results shown in Table 3. In addition, in this crystalline material, the value of a is 0, and thus the value of f is within the stable composition range of $0.0001 \leq f \leq 0.06$ obtained from the results shown in Table 5.

The thermoelectric conversion properties of $Mg_{3+m}Zn_bBi_{1.74}As_{0.25}Te_{0.01}$ at 330 K were predicted as those of $Mg_{3+m}Sb_xBi_{1.99-x-e}P_eTe_{0.01}$. Table 15 shows the calculated values.

[Table 15]

| $Mg_{3+m-b}Zn_bBi_{1.74}As_{0.25}Te_{0.01}$ | | | | | |
|---|---|---|---|---|---|
| | b | Seebeck coefficient S ($\mu$V/K) | Electrical conductivity $\sigma$ (S/cm) | Thermal conductivity $\kappa$ (W/mK) | Dimensionless figure of merit ZT |
| Ex. 34 | 0.0 | -112 | 2506 | 2.15 | 0.48 |
| Ex. 119 | 0.125 | -134 | 2061 | 1.83 | 0.67 |
| Ex. 120 | 0.25 | -134 | 1970 | 1.83 | 0.64 |
| Com. Ex. 17 | 0.375 | -108 | 2387 | 2.18 | 0.42 |

As indicated by the results in Table 15, within the composition range of $0.0 \leq b \leq 0.25$, n-type thermoelectric conversion properties were exhibited in which the Seebeck coefficient S is negative, and the thermoelectric figure of merit ZT was high enough to exceed the thermoelectric figure of merit ZT of the comparative example 17.

Tables 14 and 15 show the results of the respective cases in which one of Mn and Zn is contained. When both Mn and Zn are contained, a portion of Mg can be replaced by both the elements. Thus, a crystalline material having the composition of $Mg_{3+m-b1-b2}Mn_{b1}Zn_{b2}Bi_{1.74}As_{0.25}Te_{0.01}$ can be provided. In this case, the relation of $b = b1 + b2$ holds.

In this case, it is also understood that, when the value of b satisfies the condition of $0.0 \leq b \leq 0.25$, n-type thermoelectric conversion properties in which the value of the Seebeck coefficient S is negative are exhibited, and the thermoelectric figure of merit ZT is higher than that in the case where the condition of $b > 0.25$ is satisfied.

The results indicated in Tables 2 to 15 indicate that a crystalline material having a composition of $Mg_{3+m-a1-a2-a3-a4-b1-b2}Y_{a1}Sc_{a2}La_{a3}Ce_{a4}Mn_{b1}Zn_{b2}Sb_xBi_{1.99-x-e1-e2-f1-f2}P_{e1}As_{e2}Te_{f1}Se_{f2}$ can be provided. In this case, when the value of x is in the composition range of $0.0 \leq x \leq 1.74$, the value of e that satisfies the relation of $e = e1 + e2$ satisfies the condition of $0.001 \leq e \leq 0.25$. In addition, the value of a that satisfies the relation of $a = a1 + a2 + a3 + a4$ and the value of f that satisfies the relation of $f = f1 + f2$ satisfy the condition of $0.0001 \leq a + f \leq 0.06$. The value of b that satisfies the relation of $b = b1 + b2$ satisfies the condition of $0.0 \leq b \leq 0.25$, for example.

Industrial Applicability

A thermoelectric conversion material according to the present invention may be used in a thermoelectric apparatus that converts thermal energy to electrical energy.

Reference Signs List

100 thermoelectric conversion module
10 n-type thermoelectric conversion element
20 p-type thermoelectric conversion element
31 first electrode
32 second electrode
33 third electrode

**Claims**

1. A thermoelectric conversion material having a $La_2O_3$-type crystal structure and being of n-type,

the thermoelectric conversion material having a composition represented by the following formula (1):

$$Mg_{3+m-a-b}A_aB_bD_{2-e-f}E_eF_f \qquad \text{formula (1)}$$

wherein

D is at least one element selected from the group consisting of Sb and Bi,
E is at least one element selected from the group consisting of P and As,
m is a value of greater than or equal to -0.1 and less than or equal to 0.4,
e is a value of greater than or equal to 0.001 and less than or equal to 0.25,
A is at least one element selected from the group consisting of Y, Sc, La, and Ce,
F is at least one element selected from the group consisting of Se and Te,
a and f are values that satisfy a condition of $0.0001 \leq a + f \leq 0.06$,
B is at least one element selected from the group consisting of Mn and Zn, and
b is a value of greater than or equal to 0 and less than or equal to 0.25.

2. The thermoelectric conversion material according to claim 1, wherein E in the formula (1) includes P.

3. The thermoelectric conversion material according to claim 1 or 2, wherein E in the formula (1) includes As.

4. The thermoelectric conversion material according to any one of claims 1 to 3, wherein D in the formula (1) includes Sb and Bi, and the composition is represented by the following formula (2):

$$Mg_{3+m-a-b}A_aB_bSb_xBi_{2-e-f-x}E_eF_f \qquad \text{formula (2)}$$

wherein x is a value of greater than or equal to 0.2 and less than or equal to 1.5.

5. The thermoelectric conversion material according to any one of claims 1 to 4, wherein the value of a in the formula (1) is 0.

6. The thermoelectric conversion material according to any one of claims 1 to 4, wherein the value of a in the formula (1) is greater than or equal to 0.0001 and less than or equal to 0.04, and the value of f is 0.

7. A thermoelectric conversion element comprising the thermoelectric conversion material according to any one of claims 1 to 6.

8. A thermoelectric conversion module comprising:

   an n-type thermoelectric conversion element that is the thermoelectric conversion element according to claim 7;
   a p-type thermoelectric conversion element;
   a first electrode electrically connecting an end of the n-type thermoelectric conversion element and an end of the p-type thermoelectric conversion element to each other;
   a second electrode electrically connected to another end of the n-type thermoelectric conversion element; and
   a third electrode electrically connected to another end of the p-type thermoelectric conversion element.

9. A method of power generation comprising:

   providing the thermoelectric conversion material according to any one of claims 1 to 6 with a temperature difference; and
   deriving electric power from thermoelectromotive force generated in the thermoelectric conversion material due to the temperature difference.

10. A method of heat transfer comprising:

   allowing a current to flow through the thermoelectric conversion material according to any one of claims 1 to 6; and
   transferring heat by the current.

# FIG. 1

# FIG. 2

# FIG. 3

# FIG. 4

**EP 4 181 222 A1**

## INTERNATIONAL SEARCH REPORT

International application No.

PCT/JP2021/021701

A. CLASSIFICATION OF SUBJECT MATTER
H01L 35/16(2006.01)i; B22F 3/14(2006.01)i; C22C 1/00(2006.01)i; C22C 1/04(2006.01)i; C22C 12/00(2006.01)i
FI: H01L35/16; B22F3/14 D; B22F3/14 101B; C22C1/00 Q; C22C1/04 E; C22C12/00
According to International Patent Classification (IPC) or to both national classification and IPC

B. FIELDS SEARCHED

Minimum documentation searched (classification system followed by classification symbols)
H01L35/16; B22F3/14; C22C1/00; C22C1/04; C22C12/00

Documentation searched other than minimum documentation to the extent that such documents are included in the fields searched
Published examined utility model applications of Japan 1922–1996
Published unexamined utility model applications of Japan 1971–2021
Registered utility model specifications of Japan 1996–2021
Published registered utility model applications of Japan 1994–2021

Electronic data base consulted during the international search (name of data base and, where practicable, search terms used)
JSTPlus/JST7580 (JDreamIII)

C. DOCUMENTS CONSIDERED TO BE RELEVANT

| Category* | Citation of document, with indication, where appropriate, of the relevant passages | Relevant to claim No. |
|---|---|---|
| A | WO 2020/003554 A1 (PANASONIC IP MANAGEMENT CO., LTD.) 02 January 2020 (2020-01-02) paragraphs [0002], [0016]-[0047], [0055], fig. 1-3 | 1-10 |
| A | SHI, Xuemin et al., "Efficient Sc-Doped Mg3.05-xScxSbBi Thermoelectrics Near Room Temperarute", Chemistry of Materials, 2019, vol. 31, pp. 8987-8994, in particular, page 8988, left column, lines 9-25, page 8989, left column, lines 16-34, fig. 2 | 1-10 |

☐ Further documents are listed in the continuation of Box C.  ☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 26 August 2021 (26.08.2021) | 07 September 2021 (07.09.2021) |

| Name and mailing address of the ISA/ Japan Patent Office 3-4-3, Kasumigaseki, Chiyoda-ku, Tokyo 100-8915, Japan | Authorized officer Telephone No. |
|---|---|

Form PCT/ISA/210 (second sheet) (January 2015)

**INTERNATIONAL SEARCH REPORT**
Information on patent family members

| International application No. |
| --- |
| PCT/JP2021/021701 |

| Patent Documents referred in the Report | Publication Date | Patent Family | Publication Date |
| --- | --- | --- | --- |
| WO 2020/003554 A1 | 02 Jan. 2020 | US 2020/0006616 A1 paragraphs [0002], [0043]–[0077], [0086], fig. 1-3 CN 110998882 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6127281 B

- JP 2018190953 A

### Non-patent literature cited in the description

- **H. TAMAKI et al.** Isotropic Conduction Network and Defect Chemistry in Mg3+6Sb2-Based Layered Zintl Compounds with High Thermoelectric Performance. *Advanced Materials, (USA),* 2016, vol. 28 (46), 10182-10187
- **K. IMASATO et al.** Metallic n-Type Mg3Sb2 Single Crystals Demonstrate the Absence of Ionized Impurity Scattering and Enhanced Thermoelectric Performance. *Advanced Materials, (USA),* 2020, vol. 32 (16), 1908218
- **J. ZHANGETAL.** Discovery of high-performance low-cost n-type Mg3Sb2based thermoelectric materials with multi-valley conduction bands. *Nature Communications, (UK),* 2017, vol. 8 (13901
- **V. PONNAMBALAM.** On the Thermoelectric Properties of Zintl Compounds Mg3Bi2-xPnx (Pn = P and Sb). *Journal of Electronic Materials, (USA),* 2013, vol. 42 (7), 1307-1312
- Thermoelectric properties of Mn-doped Mg-Sb single crystals. *Journal of Materials Chemistry A, (UK),* 2014, vol. 2, 12311-12316
- **X. SHI.** Efficient Sc-doped MgScSbBi thermoselectrics near room temperature. *Chemistry of Materials, (USA),* 2019, vol. 31 (21), 8987-8994

- **S. W. SONG.** Joint effect of magnesium and yttrium on enhancing thermoelectric properties of n-type Zintl Mg3+δY0.02Sb1.5Bi0.5. *Materials Today Physics, (Netherlands),* 2019, vol. 8, 25-33
- **K. IMASATO et al.** Improved stability and high thermoelectric performance through cation site doping in n-type La-doped Mg3Sb1.5Bi0.5. *Journal of Materials Chemistry A, (UK),* 2018, vol. 6, 19941-19946
- **J. LI et al.** Defect Chemistry for N-Type Doping ofMg3Sb2-Based Thermoelectric Materials. *Journal of Physical Chemistry C, (USA),* 2019, vol. 123, 20781-20788
- **K. IMASATO et al.** Exceptional thermoelectric performance in Mg3Sb0.6Bi1.4for low-grade waste heat recovery. *Energy & Environmental Science, (UK),* 2019, vol. 12, 965-971
- **C. G. VAN DE WALLE et al.** First-principles calculations for defects and impurities: Applications to III-nitrides. *Journal of Applied Physics, (USA),* 2004, vol. 95, 3581-3879
- *Journal of Materials Chemistry A, (UK),* 2014, vol. 2, 11235-11245
- **H. J. GOLDSMID.** Introduction to Thermoelectricity. Springer, 2010